(19) **Europäisches Patentamt / European Patent Office / Office européen des brevets**

(11) **EP 2 577 737 B1**

(12) **FASCICULE DE BREVET EUROPEEN**

(45) Date de publication et mention
de la délivrance du brevet:
**13.07.2016 Bulletin 2016/28**

(21) Numéro de dépôt: **11726735.1**

(22) Date de dépôt: **31.05.2011**

(51) Int Cl.:
*H01L 31/04* *(2006.01)*     *H01L 31/042* *(2006.01)*
*H01L 31/18* *(2006.01)*

(86) Numéro de dépôt international:
**PCT/EP2011/058971**

(87) Numéro de publication internationale:
**WO 2011/151338 (08.12.2011 Gazette 2011/49)**

(54) **COMPOSANT PHOTOVOLTAÏQUE POUR APPLICATION SOUS FLUX SOLAIRE CONCENTRÉ**

FOTOVOLTAISCHES BAUTEIL ZUR VERWENDUNG UNTER KONZENTRIERTER SONNENSTRAHLUNG

PHOTOVOLTAIC COMPONENT FOR USE UNDER CONCENTRATED SOLAR RADIATION

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **02.06.2010 FR 1054318**

(43) Date de publication de la demande:
**10.04.2013 Bulletin 2013/15**

(73) Titulaires:
• **Centre National de la Recherche Scientifique (CNRS)**
**75794 Paris Cedex 16 (FR)**
• **Université Pierre et Marie Curie (Paris 6)**
**75252 Paris Cedex 05 (FR)**
• **Electricité de France (EDF)**
**75382 Paris Cedex 08 (FR)**

(72) Inventeurs:
• **LINCOT, Daniel**
**F-92160 Antony (FR)**

• **PAIRE, Myriam**
**F-75017 Paris (FR)**
• **GUILLEMOLES, Jean-François**
**F-75013 Paris (FR)**
• **PELOUARD, Jean-Luc**
**F-75020 Paris (FR)**
• **COLLIN, Stéphane**
**F-75013 Paris (FR)**

(74) Mandataire: **Osha Liang**
**2, rue de la Paix**
**75002 Paris (FR)**

(56) Documents cités:
WO-A2-2009/107943     JP-A- 2008 124 381
US-A- 4 834 805     US-A1- 2009 293 934

• **J. R. TUTTLE ET AL: "The Performance of Cu(In, Ga)Se2-Based Solar Cells in Conventional and Concentrator Applications", MRS PROCEEDINGS, vol. 426, 1 janvier 1996 (1996-01-01), XP55033857, DOI: 10.1557/PROC-426-143**

EP 2 577 737 B1

## EP 2 577 737 B1

**Description**

**Domaine technique de l'invention**

La présente invention concerne un composant photovoltaïque pour application sous flux solaire concentré et son procédé de fabrication et concerne notamment la filière des cellules photovoltaïques en couches minces.

**Etat de l'art**

Dans le domaine des cellules solaires, on observe une activité intense dans les filières à base de couches minces aux dépens du silicium cristallin traditionnellement utilisé. Cet engouement industriel est dû principalement au fait que ces films, d'épaisseur inférieure à 20 $\mu$m, typiquement inférieure à 5 $\mu$m, ont un coefficient d'absorption de la lumière solaire de plusieurs ordres de grandeur supérieur au silicium cristallin et qu'ils sont produits directement à partir de la phase gazeuse ou liquide sans nécessiter de découpe. Ainsi, un module photovoltaïque en films minces peut être réalisé avec une couche 100 fois plus mince qu'une cellule photovoltaïque cristalline. Il en résulte que les coûts attendus sont beaucoup plus faibles, la disponibilité des matériaux de base augmentée et le procédé de fabrication des modules plus simple. Les principales filières développées aujourd'hui sont les filières chalcogénures polycristallins, avec notamment la filière CdTe et la filière appelée chalcopyrite basée sur le composé CuInSe$_2$ ou ses variantes Cu(In,Ga)(S,Se)$_2$ encore dénommée CIGS, et les filières silicium amorphe et microcristallin.

Les cellules solaires en couches minces, notamment à base de matériaux chalcopyrites Cu(In,Ga)Se$_2$ ou CdTe, atteignent aujourd'hui des rendements en laboratoire de 20% et 16,5% respectivement sous illumination d'un soleil (c'est-à-dire 1000W/m$^2$). Cependant, les matériaux utilisés pour fabriquer les cellules solaires peuvent avoir une disponibilité limitée (Indium ou tellure par exemple). Dans la perspective du développement du photovoltaïque à des niveaux de production de l'ordre de plusieurs GW, les problèmes de disponibilité des matières premières pourront devenir des freins majeurs.

Récemment, on a vu se développer la filière du photovoltaïque à concentration, ou CPV (abréviation de l'expression anglosaxonne 'Concentration PhotoVoltaics') mettant en oeuvre des cellules photovoltaïques utilisées sous flux solaire concentré. La concentration lumineuse permet d'augmenter le rendement de conversion de la cellule et donc d'économiser les matières premières par un facteur supérieur à la concentration lumineuse employée, pour la même production d'électricité. Ceci est un élément particulièrement important pour la filière des couches minces. Des essais sous concentration ont prouvé que des rendements de 21,5% pouvaient être obtenus sous faible concentration (14 soleils, soit 14 fois la puissance lumineuse moyenne reçue par la terre du soleil), si la grille de collecte en face avant était optimisée (voir par exemple J.Ward et al. « Cu(In,Ga)Se2 Thin film concentrator Solar Cells », Progress in Photovoltais 10, 41-46, 2002). Au delà de cette concentration les effets dissipatifs dus à la résistance de couche de collecte deviennent trop importants pour que les rendements soient améliorés, quelque soit le dessin de la grille en face avant, qui par ailleurs ombre la cellule (jusqu'à 16% d'ombrage). Le photovoltaïque à concentration, en plein essor aujourd'hui, reste ainsi limité à des cellules simple jonction ou multijonction de semi-conducteurs III-V, très coûteuses.

Le document JP2008124381 décrit un composant photovoltaïque en couche minces dans lequel une superposition de couches semi-conductrices absorbantes est gravée en îlots pour former des rainures d'isolation ; dans ce composant, l'électrode avant vient nécessairement ombrager la zone active photovoltaïque.

Un objet de l'invention est la réalisation d'une cellule photovoltaïque permettant de travailler sous très forte concentration avec une forte réduction des effets préjudiciables de la résistance de la couche avant. Pour cela, une architecture innovante a été mise au point, permettant notamment la conception d'ensembles de microcellules contactées en périphérie, ce qui permet de s'affranchir de l'utilisation d'une grille de collecte. Cette architecture est compatible avec les filières de cellules solaires existantes, notamment les filières couches minces et pourrait permettre d'économiser de façon considérable l'utilisation d'éléments chimiques rares (indium, tellure, gallium).

RESUME DE L'INVENTION

L'invention concerne un composant photovoltaïque tel que défini dans la revendication 1.

Par exemple, ledit matériau conducteur formant la couche en matériau conducteur en contact électrique avec ladite troisième couche en matériau conducteur transparent est un métal choisi parmi l'aluminium, le molybdène, le cuivre, le nickel, l'or, l'argent, le carbone et les dérivés du carbone, le platine, le tantale, le titane.

Selon une variante, la première couche en matériau conducteur du contact arrière est transparente et le contact arrière comprend en outre une couche en matériau conducteur, en contact électrique avec ladite couche en matériau conducteur transparent, structurée de telle sorte à former un contact électrique périphérique pour lesdites microcellules photovoltaïques.

Selon une variante, la couche isolante comprend une couche en matériau isolant structurée de telle sorte à

2

présenter une pluralité d'ouvertures.

Selon une variante, le composant photovoltaïque selon le premier aspect comprend en outre une seconde couche en matériau isolant agencée entre ledit contact électrique arrière et ledit contact électrique avant, structurée de telle sorte à présenter plusieurs ouvertures centrées sur lesdites ouvertures de la première couche en matériau isolant, de dimensions égales ou inférieures.

Par exemple, ledit matériau isolant est choisi parmi les oxydes tels que la silice ou l'alumine, les nitrures tels que le nitrure de silicium, les sulfures tels que le sulfure de zinc.

Alternativement, la couche isolante comprend un gaz isolant, par exemple de l'air.

Selon une variante préférée de l'invention, au moins une dimension de la section des microcellules photovoltaïques est inférieure à 1 mm, préférentiellement inférieure à 100 $\mu$m

Selon une variante, au moins une partie des microcellules photovoltaïques sont de section circulaire, de surface inférieure à $10^{-2}$ cm$^2$, préférentiellement inférieure à $10^{-4}$ cm$^2$.

Selon une variante, le composant photovoltaïque selon le premier aspect comprend au moins une microcellule photovoltaïque de section allongée, en forme de bande, de plus petite dimension inférieure à 1 mm, préférentiellement inférieure à 100 $\mu$m.

Selon une variante, la couche en matériau absorbant est discontinue, formée à l'endroit des microcellules photovoltaïques.

Selon une variante préférée de l'invention, le composant photovoltaïque est un composant en couches minces, chacune desdites couches formant la cellule ayant une épaisseur inférieure à 5 $\mu$m.

Par exemple, le matériau absorbant appartient à l'une des familles parmi la famille du CIGS, la famille du CdTe, la famille du silicium, la famille des semi-conducteurs III-V.

Selon un second aspect, l'invention concerne un ensemble de composants photovoltaïques selon le premier aspect, dans lequel lesdits composants photovoltaïques sont connectées électriquement en série, le contact avant d'un composant photovoltaïque étant connecté électriquement au contact arrière du composant photovoltaïque adjacent.

Selon un troisième aspect, l'invention concerne un module photovoltaïque comprenant une ou un ensemble de composants photovoltaïques selon le premier ou selon le second aspect, et comprenant en outre un système de concentration de la lumière solaire adapté pour focaliser tout ou partie de la lumière incidente sur chacune desdites microcellules photovoltaïques.

Selon une variante, le contact électrique arrière comprenant une couche en matériau conducteur transparent et une couche en matériau conducteur structurée de telle sorte à former un contact électrique périphérique pour lesdites microcellules photovoltaïques, le module photovoltaïque selon le troisième aspect comprend en outre un élément de conversion de la longueur d'onde de la lumière incidente dans une bande spectrale d'absorption du matériau absorbant, agencé sous la couche en matériau transparent du contact arrière.

Selon un quatrième aspect, l'invention concerne une méthode de fabrication d'un composant photovoltaïque selon le premier aspect, comprenant le dépôt sur un substrat desdites couches formant le composant.

Selon une variante, la méthode de fabrication comprend :

- le dépôt sur un substrat de ladite première couche en matériau conducteur pour former le contact électrique arrière,
- le dépôt d'une couche en matériau inactif pour le dispositif photovoltaïque, préférentiellement électriquement isolant, ladite couche inactive étant structurée pour former une pluralité d'ouvertures,
- le dépôt sélectif du matériau absorbant dans lesdites ouvertures pour former ladite deuxième couche en matériau absorbant, ladite couche étant discontinue,
- le dépôt de ladite couche en matériau conducteur, structurée de telle sorte à former des ouvertures de dimensions inférieures ou égales à celles des ouvertures de ladite couche inactive,
- le dépôt de ladite troisième couche en matériau conducteur transparent, en contact électrique avec ladite couche en matériau conducteur structurée, pour former le contact électrique avant.

Selon une variante, la méthode de fabrication comprend :

- le dépôt sur un substrat de ladite première couche en matériau conducteur pour former le contact électrique arrière,
- le dépôt de ladite deuxième couche en matériau absorbant, ladite couche étant discontinue pour former une pluralité d'ouvertures,
- le dépôt sélectif dans lesdites ouvertures d'un matériau inactif dans le dispositif photovoltaïque, préférentiellement électriquement isolant, pour former une couche inactive discontinue avec des ouvertures à l'endroit du matériau absorbant,
- le dépôt de ladite couche en matériau conducteur, structurée de telle sorte à former des ouvertures de dimensions inférieures ou égales à celles des ouvertures de ladite couche inactive,
- le dépôt de ladite troisième couche en matériau conducteur transparent en contact électrique avec ladite couche en matériau conducteur structurée pour former le contact électrique avant.

Selon une variante, la méthode de fabrication comprend :

- le dépôt sur un substrat de ladite première couche en matériau conducteur pour former le contact électrique arrière et de ladite deuxième couche en matériau absorbant,
- le dépôt d'une couche de résine structurée pour former un ou plusieurs plots dont la forme définira la forme de chacune des microcellules photovoltaïques,
- le dépôt sur ladite couche de résine d'une couche en matériau isolant et d'une couche en matériau conducteur,
- le lift-off de la résine permettant d'obtenir lesdites couches en matériau isolant et en matériau conducteur structurées, et le dépôt de ladite troisième couche en matériau conducteur transparent, en contact électrique avec ladite couche en matériau conducteur structurée, pour former le contact électrique avant.

Selon une variante, la méthode de fabrication comprend :

- le dépôt sur un substrat transparent de ladite troisième couche en matériau conducteur transparent pour former le contact électrique avant,
- le dépôt d'une couche de résine structurée pour former une pluralité de plots dont la forme définira la forme de chacune des microcellules photovoltaïques,
- le dépôt sur ladite couche de résine d'une couche en matériau conducteur et d'une couche en matériau isolant,
- le lift-off de la résine permettant d'obtenir lesdites couches en matériau isolant et en matériau conducteur structurées, et le dépôt de la couche en matériau absorbant,
- le dépôt de ladite première couche en matériau conducteur pour former le contact électrique arrière.

Avantageusement, ladite couche en matériau absorbant est formée de façon sélective, et forme une couche discontinue.

BREVE DESCRIPTION DES DESSINS

D'autres avantages et caractéristiques de l'invention apparaîtront à la lecture de la description, illustrée par les figures suivantes :

- Figures 1A à 1C, des schémas de principe de microcellules selon l'invention selon différentes variantes ;

- Figure 2, un schéma illustrant la connexion en série de deux îlots comprenant chacun un ensemble de microcellules selon l'invention ;

- Figures 3A à 3D, des schémas illustrant des empilements de couches pour la formation de cellules selon l'invention dans différentes variantes de réalisation ;

- Figures 4A à 4C des schémas illustrant des exemples de réalisation de cellules selon l'invention dans le cas respectivement d'une jonction CIGS, CdTe, Si amorphe, Si cristallin ; Figure 4D : exemple comparatif ne faisant pas partie de l'invention.

- Figures 5A à 5F, des schémas illustrant selon un exemple la méthode de fabrication d'un îlot de microcellules selon l'invention, dans le cas d'une jonction de type CIGS ;

- Figure 6, une courbe illustrant l'efficacité évaluée d'une cellule solaire selon un exemple de réalisation de l'invention, en fonction de la puissance incidente ;

- Figure 7, une courbe illustrant l'efficacité évaluée de la cellule solaire selon l'exemple de la figure 6, en fonction de la surface de la zone active de la cellule ;

- Figures 8A et 8B des photos d'une microcellule réalisée selon un exemple de procédé selon l'invention.

DESCRIPTION DETAILLEE

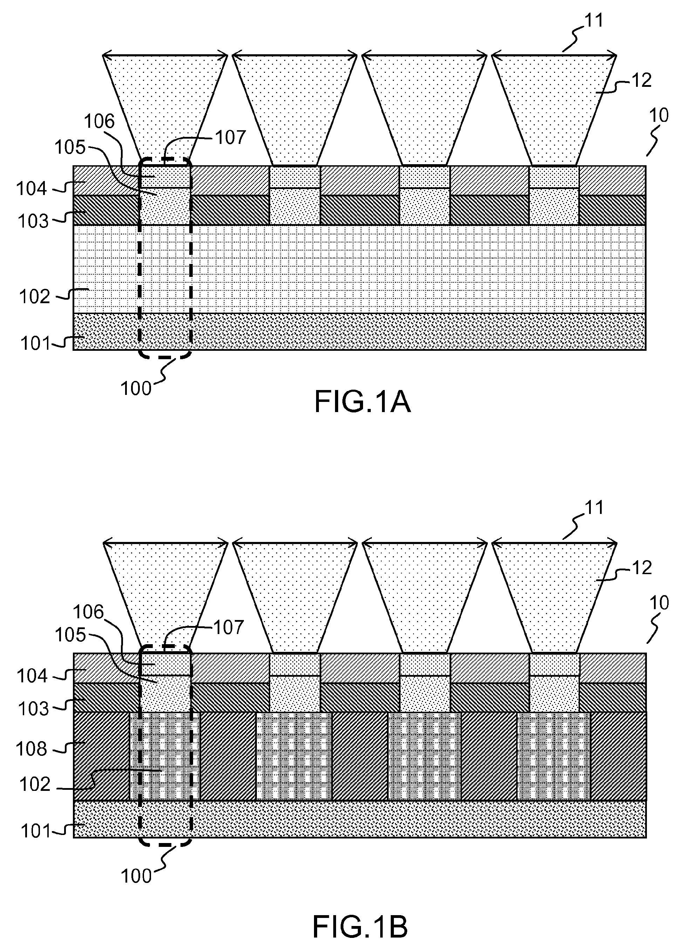

Les figures 1A à 1C représentent des schémas de principe de modules photovoltaïques avec des cellules photovoltaïques selon différentes variantes de la présente invention. Ces schémas sont illustratifs et les dimensions figurées ne correspondent pas à l'échelle réelle des cellules.

Sur ces exemples est représenté un composant photovoltaïque 10, formant un îlot ou ensemble de microcellules photovoltaïques ou zones actives photovoltaïques 100, présentant une surface d'exposition 107 à la lumière solaire incidente de forme et de dimensions données, telles qu'une dimension au moins de la surface d'exposition soit inférieure à quelques centaines de microns, avantageusement inférieure à environ 100 $\mu$m. Les microcellules sont associées à un système de concentration de la lumière solaire (symbolisé sur les figures par les microlentilles 11) permettant de concentrer tout ou partie la lumière solaire incidente sur chacune des surfaces 107 des microcellules 100 (flux lumineux indiqué par la référence 12).

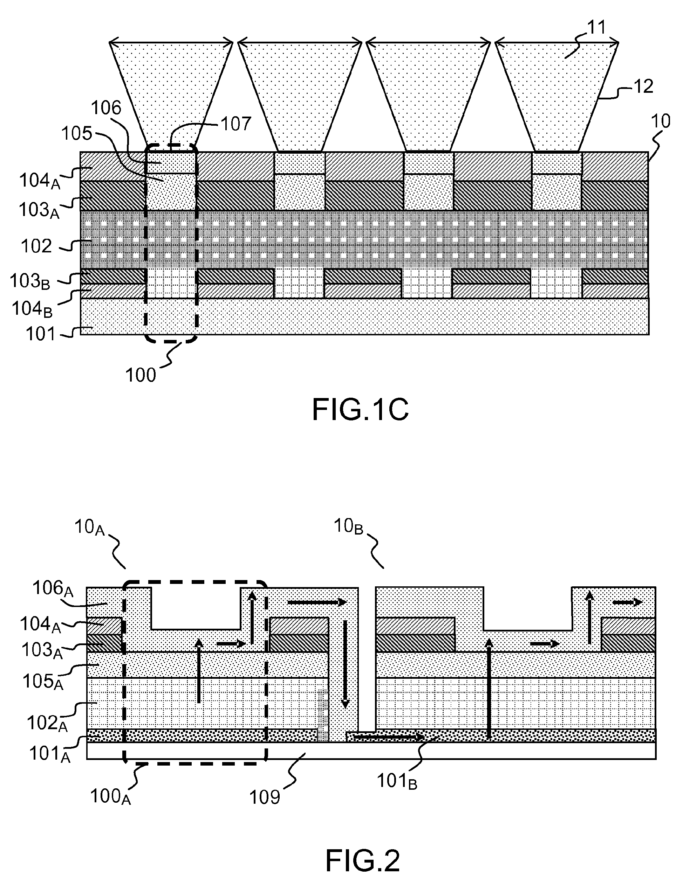

Chaque microcellule comprend un empilement de couches adaptées à la réalisation d'un dispositif photovoltaïque, avec notamment une couche 102 en matériau absorbant dans le spectre visible et ou proche infrarouge (gamme spectrale solaire), ou dans une partie du spectre solaire, une couche 101 d'un matériau conducteur pour former un contact électrique arrière et une couche 106 d'un matériau conducteur transparent, recouvrant la surface d'exposition 107, pour former un contact électrique avant, la couche 106 étant appelée également couche fenêtre. Selon la nature du dispositif photovoltaïque que l'on souhaite réaliser, une ou plusieurs couches additionnelles 105 peuvent être prévues, par exemple des couches en matériau semi-conducteur ou des couches d'interface qui, avec la couche 102 en matériau absorbant, vont contribuer à former une jonction. Dans les figures 1A, 1B et 1C le contact électrique avant est réalisé par les couches 104, 106, comme cela sera détaillé par la suite. Dans les exemples des figures 1A à 1C, les microcellules 100 sont contactées en parallèle à la fois par le contact électrique avant (106 et/ou 104) et le contact électrique arrière 101, communs à l'ensemble des microcellules.

Selon une variante, le système de concentration de la lumière permet de focaliser sur chaque microcellule une lumière présentant un spectre adapté à la plage d'absorption du matériau absorbant de ladite microcellule.

L'îlot 10 comprend une couche électriquement isolante 103 agencée entre le contact électrique arrière et le contact électrique avant. La couche isolante 103 est discontinue de telle sorte à présenter une ou plusieurs ouvertures qui définissent la forme et les dimensions des microcellules ou zones actives photovoltaïques 100 de l'îlot 10. En dehors de ces ouvertures en effet, les densités de courant d'obscurité sont négligeables. Au niveau des ouvertures, la jonction est assurée par l'empilement des couches en matériau semi-conducteur. Les contacts électriques avant et arrière permettent d'évacuer les charges photo générées. Ainsi, en choisissant les dimensions des microcellules (dont les sections sont définies par les ouvertures formées dans la couche isolante) de telle sorte qu'une dimension au moins d'une section de la microcellule soit inférieure à quelques centaines de microns, les déposants ont montré que les charges photo générées au niveau de chaque microcellule pouvaient s'évacuer grâce au contact électrique avant en limitant les pertes dues à la résistance de la couche conductrice transparente contribuant à ce contact. L'ensemble ainsi constitué forme une cellule solaire adaptée à une application sous flux solaire concentré qui ne nécessite pas l'utilisation d'une grille de collecte. Les déposants ont montré que grâce à cette structure originale, des efficacités théoriques de 30% pouvaient être atteints sous concentration de plus de 40 000 soleils pour des cellules dont l'efficacité est de 20% sans concentration, dépassant considérablement les limites des concentrations proposées jusqu'alors dans les réalisations de l'art antérieur.

Dans les figures 1A à 1C, les microcellules 100 sont par exemple à section ronde, de surface avantageusement inférieure à $10^{-2}$ cm$^2$, voire inférieure à $10^{-4}$ cm$^2$ et jusqu'à $10^{-8}$ cm$^2$ ou moins, pour permettre une évacuation rapide des charges. La limite inférieure de la surface est liée à des considérations technologiques et aux propriétés de mobilité et de durée de vie des porteurs photogénérés dans la couche en matériau absorbant.

L'isolant peut être une couche formée d'un matériau isolant électrique percée d'ouvertures, comme un oxyde, type silice ($SiO_2$) ou alumine ($Al_2O_3$), un nitrure, par exemple du nitrure de silicium ($Si_3N_4$), un sulfure, par exemple du sulfure de zinc (ZnS), ou tout autre matériau isolant compatible avec le procédé de fabrication de la cellule, par exemple un matériau polymère.

La section définit la surface d'exposition 107 des zones actives photovoltaïques à la lumière incidente et le système de concentration de la lumière 11 devra être adapté pour focaliser la lumière incidente sur les surfaces d'exposition des microcellules. Par exemple dans le cas de microcellules à section circulaire, un système comprenant un réseau de microlentilles pourra être utilisé, ou tout autre système de focalisation de la lumière connu. Le système de concentration de la lumière s'adaptant aux dimensions des surfaces d'illumination, il va se trouver lui-même réduit en volume par rapport à un système de concentration utilisé avec une cellule classique. Cela procure un avantage supplémentaire lié au gain de matière réalisé également sur le système de concentration de la lumière.

La section des microcellules peut prendre différentes formes. Par exemple, on peut envisager une section de forme allongée, par exemple une bande, la dimension transversale très petite, typiquement inférieure au millimètre, avantageusement inférieure à la centaine de microns et jusqu'à quelques microns ou moins. Les charges photogénérées au niveau de la jonction peuvent alors s'évacuer au niveau du contact avant selon la plus petite dimension de la bande, permettant là encore de limiter les effets de résistance de la couche fenêtre formée par la couche en matériau conducteur transparent du contact avant. Dans ce cas, le système de concentration de la lumière sera adapté pour une focalisation selon une ou plusieurs lignes suivant la structure de l'îlot, à une ou plusieurs bandes. Si l'îlot comprend une pluralité de bandes, ces bandes pourront être connectées électriquement en parallèle à la fois par le contact arrière et le contact avant. D'autres formes sont envisageables, comme par exemple une forme allongée en serpentin, etc., tant qu'on conserve une des dimensions de la section petite, typiquement inférieure à quelques centaines de microns, pour l'évacuation des charges. En particulier, les dimensions pourront être optimisées en fonction des matériaux utilisés, notamment pour minimiser l'influence des recombinaisons électriques latérales.

Les charges générées dans la couche 102 au niveau de la zone active délimitée par la surface d'exposition 107 s'évacuent au niveau de la couche en matériau conducteur transparent 106 ou couche fenêtre, d'abord dans la direction perpendiculaire au plan des couches, puis vers la périphérie de la microcellule. Cette couche doit être suffisamment transparente pour laisser le maximum de lumière solaire pénétrer dans la zone photovoltaïque active 100. Elle présente donc une certaine résistivité pouvant générer des pertes mais dont l'effet va être limité du fait de la taille de la microcellule.

Les déposants ont montré qu'une évacuation périphérique des charges était nettement améliorée en associant à la couche fenêtre une couche en matériau conducteur 104, en contact électrique avec la couche fenêtre 106, l'ensemble des deux couches formant alors le contact avant. La couche en matériau conducteur 104 est par exemple en métal, par exemple en or, argent, aluminium, molybdène, cuivre, nickel, en fonction de la nature des couches à empiler, ou en matériau semi-conducteur dopé, par exemple ZnO :Al suffisamment dopé en aluminium pour obtenir la conductivité recherchée. Comme la couche isolante 103, la couche en matériau conducteur 104 est discontinue, percée d'ouvertures qui peuvent se superposer sensiblement à celles de la couche isolante pour ne pas entraver la fonction photovoltaïque de la microcellule 100. Les charges photogénérées dans la couche active 102 au niveau de la zone active s'évacuent dans la direction perpendiculaire au plan des couches grâce à la couche fenêtre 106 puis l'évacuation vers la périphérie de la microcellule est facilitée par la couche 104 conductrice qui forme ainsi un contact périphérique de la microcellule.

La couche 104 formant le contact périphérique des microcellules peut recouvrir complètement la surface entre les microcellules, ou peut être structurée de telle sorte à présenter des zones de contact périphériques avec chacune des microcellules et des zones de liaison électrique entre lesdites zones de contact périphériques, non recouvrantes.

Les zones actives photovoltaïques de la cellule 10 étant délimitées par les dimensions de la ou des ouvertures de la couche isolante pour former des microcellules, il est possible de limiter la quantité de matériau des couches formant le dispositif photovoltaïque, et notamment la quantité de matériau absorbant. Ainsi, dans l'exemple de la figure 1B, la couche absorbante 102 est discontinue, limitée à des zones situées au niveau des zones actives 107. Le reste de la structure peut être rempli par une couche 108 inactive du point de vue de la jonction, qui peut être en matériau isolant, du même matériau que la couche 103. Avantageusement, la zone comprenant le matériau absorbant est légèrement plus large que la zone active photovoltaïque définie par l'ouverture dans la couche isolante 103 (typiquement quelques microns), permettant ainsi de rendre marginale l'influence sur la microcellule photovoltaïque de défauts de surface pouvant être liés au matériau lui-même ou au procédé de fabrication.

La figure 1C représente une variante dans laquelle la couche 101 en matériau conducteur est transparente et le contact arrière est formé, comme le contact avant ($104_A$, 106), de la couche 101 et d'une couche $104_B$ en matériau conducteur, par exemple en métal, la couche $104_B$ étant structurée comme la couche $104_A$ de telle sorte à former un contact électrique périphérique pour les zones actives photovoltaïques. Cette variante présente l'avantage de proposer un contact arrière avec une couche fenêtre transparente, formant ainsi des cellules bifaciales, ceci étant rendu possible par l'évacuation périphérique des charges et la limitation des pertes dues à la résistance de la couche fenêtre transparente même sous concentration. Cela permet différentes applications, comme par exemple la réalisation de multijonctions dans lesquelles deux cellules photovoltaïques ou plus sont superposées l'une sur l'autre. Ou selon un autre exemple, cela permet d'associer à la cellule photovoltaïque d'un dispositif de conversion lumineuse agencé sous la couche fenêtre du contact arrière, permettant de renvoyer dans la cellule la lumière non absorbée lors du premier passage dans la cellule (par exemple lumière dans le proche infrarouge) et dont la longueur d'onde a été modifiée (par exemple vers la gamme visible, ou plus généralement dans la gamme spectrale de meilleure absorption du matériau absorbant, en utilisant un matériau dit à 'up conversion').

Sur la figure 1C est représentée une autre variante dans laquelle une deuxième couche en matériau isolant $103_B$ est prévue, structurée de façon sensiblement identique à la première couche en matériau isolant $103_A$, avec une ou plusieurs ouvertures centrées sur la ou le(s) ouverture(s) de la couche en matériau isolant $103_A$, de dimensions identiques ou légèrement inférieures. Cette deuxième couche peut avoir pour effet par exemple de concentrer les lignes de courant dans un volume actif photovoltaïque.

Selon une variante représentée sur la figure 2, plusieurs îlots ($10_A$, $10_B$) peuvent être connectés électriquement pour former une cellule photovoltaïque de plus grandes dimensions. Les îlots sont par exemple formés sur un substrat commun 109. Sur la figure 2, une seule microcellule 100 est représentée par îlot, mais bien entendu, chaque îlot peut comprendre une pluralité de microcellules. Dans cet exemple, comme dans celui des figures 1A et 1B, le contact électrique avant comprend une couche en matériau conducteur ($104_A$, $104_B$) et une couche fenêtre ($106_A$, $106_B$) qui recouvre dans cet exemple l'ensemble de l'îlot. Dans cet exemple, les îlots sont connectés en série au moyen par exemple de la couche fenêtre $106_A$ du premier îlot $10_A$ en contact électrique avec le contact électrique arrière $101_B$ du deuxième îlot $10_B$. Il s'entend que la figure 2 est un schéma de principe. Il peut être nécessaire en cas de conductivité élevée de la couche $102_A$ de prévoir une stratégie d'isolation avec la couche $106_A$, par exemple par une extension de la couche isolante $103_A$ au niveau de la connexion des îlots.

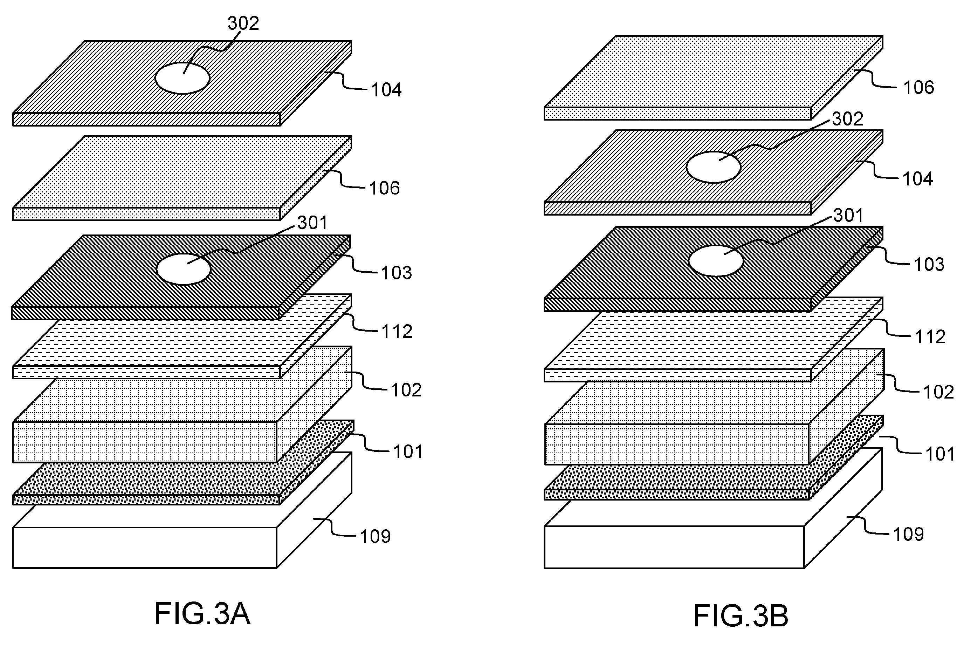

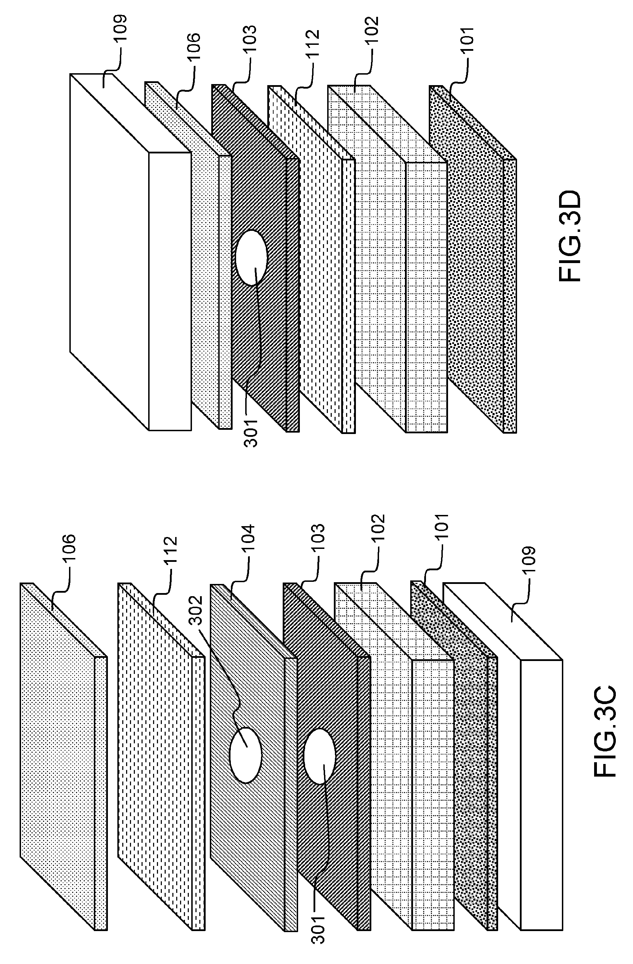

Les Figures 3A à 3D représentent des schémas illustrant la succession des couches utilisées pour la formation de cellules selon l'invention dans différentes variantes de réalisation. Plusieurs architectures sont ici présentées pour la réalisation de microcellules en couches minces. Dans cet exemple de réalisation, le dispositif photovoltaïque comprend une jonction formée au moyen de couches de semi-conducteur dopées n et p, la couche électriquement isolante 103 étant interposée entre lesdites couches. Dans ces exemples, les couches formant la jonction sont les couches 102 (couche en matériau absorbant), 112 (représentant une ou plusieurs couches d'interface) et 106 (qui forme la couche fenêtre transparente). Une structuration de la couche isolante permet de créer des disques 301 d'aire contrôlée dans lesquels cette couche n'est pas déposée. La couche isolante permet de définir des cellules photovoltaïques circulaires, puisque la jonction de semiconducteurs de type p/n ou n/p ne pourra être formée qu'au niveau des disques. La couche 104 électriquement conductrice, par exemple en métal, structurée de façon similaire à la couche isolante (comportant des trous circulaires 302), est agencée pour être en contact électrique avec la couche fenêtre 106 afin de former, avec la couche fenêtre, le contact en face avant (sauf dans l'exemple de la figure 3D où seule la couche 106 forme le contact avant). Soit la couche conductrice 104 est déposée sur la couche isolante 103 (figure 3B), avant le dépôt de la couche fenêtre 106, soit elle est déposée sur la couche fenêtre (figure 3A). Les couches d'interfaces 112 peuvent être déposées avant la couche isolante (figures 3A, 3B) ou après celle-ci (figure 3C), le contact électrique entre la couche métallique et la couche fenêtre étant conservé si la couche d'interface est suffisamment fine. La présence de couches d'interface ayant une très faible conductivité latérale (CdS et ZnO intrinsèque dans le cas d'une cellule CIGS par exemple) permet de faire en sorte que la jonction d'un point de vue optique et la jonction d'un point de vue électrique soient similaires. Ainsi, les parties actives électriquement sont bien excitées par la lumière incidente, tout en minimisant les pertes dues à la recombinaison des porteurs de charge et le courant d'obscurité de la jonction.

On peut aussi adapter cette géométrie au cas des cellules superstrate (figure 3D) réalisées sur un substrat en verre 109 par un procédé dit 'de haut en bas' tel qu'il sera décrit par la suite, puis retournée pour laisser entrer la lumière incidente par la face correspondant au substrat.

Comme cela a été précédemment décrit, la couche conductrice 104, par exemple en métal, permet de faire un contact annulaire à la périphérie de la microcellule, et, commune à l'ensemble des microcellules, peut être utilisée directement comme le contact électrique avant de la cellule, ce qui permet une minimisation des résistances de contact tout en évitant un ombrage de la cellule puisque aucune grille de collecte n'est nécessaire. L'intercalation de la couche 103 en matériau isolant structurée avec une ou plusieurs ouvertures dans l'empilement des couches formant le dispositif photovoltaïque est un moyen avantageux pour définir les microcellules car cette solution ne requiert pas de gravure mécanique de l'empilement, qui est une source de défauts inévitables.

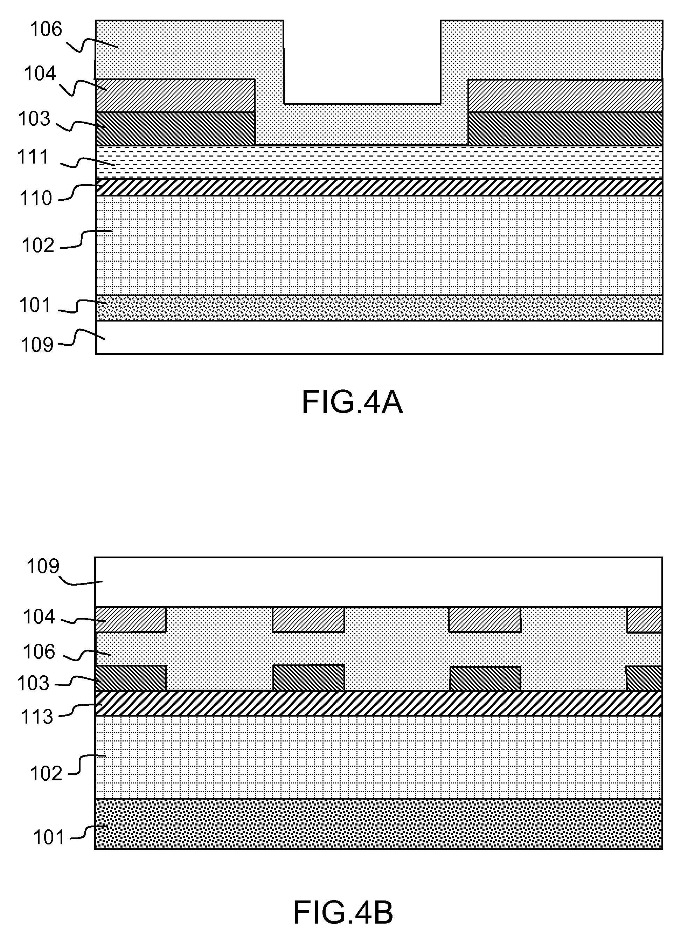

Les figures 4A à 4D proposent quatre exemples de réalisation de cellules selon l'invention utilisant respectivement les familles du CIGS, CdTe et du silicium. Dans chacun de ces exemples, l'ensemble de la cellule photovoltaïque n'est pas représenté, mais seulement l'empilement des couches au niveau d'une microcellule. Là encore, il s'agit de schémas illustratifs dont les dimensions ne correspondent pas à l'échelle réelle des cellules.

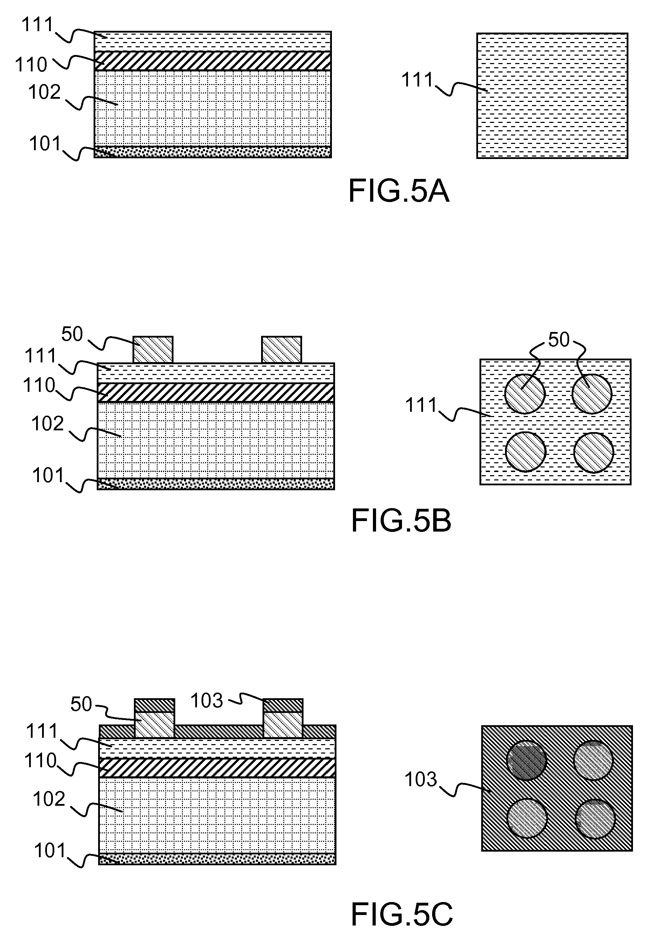

La figure 4A représente un empilement de couches adapté pour la formation de microcellules photovoltaïques avec une hétérojonction de type CIGS. Par CIGS, on entend ici de façon plus générale la famille du CuInSe2 ou un de ses alliages ou dérivés, dans lequel le cuivre peut être substitué partiellement par l'argent, l'indium peut être substitué partiellement par l'aluminium ou le galium, et le sélénium peut être substitué partiellement par le soufre ou le tellure. Les natures des matériaux sont données ci-dessous à titre d'exemple, et peuvent être substituées par tout autre matériau connu de l'homme de l'art pour obtenir un dispositif photovoltaïque fonctionnel. Dans l'exemple illustré par la figure 4A, l'empilement comprend un substrat 109, par exemple en verre, l'épaisseur du substrat étant typiquement de quelques millimètres, une couche 101 en matériau conducteur, par exemple en molybdène, pour former le contact arrière. L'épaisseur de cette couche est de l'ordre du micromètre. La couche 102 est la couche en matériau semi-conducteur absorbant, dans cet exemple du $Cu(In,Ga)Se_2$ (diséléniure de cuivre indium et gallium). Son épaisseur est de quelques micromètres, par exemple 2 ou 3 $\mu$m. Les couches 110 et 111 sont les couches d'interface, respectivement en CdS (sulfure de cadmium) dopé n et iZnO (oxyde de Zinc intrinsèque), d'épaisseurs quelques dizaines de nanomètres, par exemple 50 nm. De façon générale, les couches d'interface permettent de passiver les défauts électriques présents lors du contact direct entre la couche de matériau absorbant (ici le CIGS) et la couche en matériau conducteur transparent, ces défauts pouvant limiter fortement le rendement des cellules. D'autres matériaux peuvent être utilisés pour former une couche d'interface, comme par exemple les dérivés du sulfure de zinc $(Zn,Mg)(O,S)$ ou le sulfure d'indium $In_2S_3$. L'empilement comprend la couche 103 en matériau électriquement isolant, par exemple en $SiO_2$ (silice), structurée pour former les ouvertures permettant de définir la ou les zone(s) active(s) photovoltaïque(s). Son épaisseur est de quelques centaines de nanomètres, par exemple 400 nm. La couche 104 est une couche en matériau conducteur, par exemple une couche métallique, pour assurer le contact périphérique de la microcellule. Elle est structurée de façon identique à la couche isolante 103. Son épaisseur fait quelques centaines de nanomètres, par exemple 300 nm. Elle est formée par exemple en or, cuivre, aluminium, platine ou nickel. Elle pourrait également être formée en ZnO :Al fortement dopé en aluminium. Enfin la couche 106 par exemple en ZnO :Al (oxyde de Zinc dopé aluminium) dopé n, forme la couche fenêtre avant et contribue aussi à la jonction. Son épaisseur est également de quelques centaines de nanomètres, par exemple 400 nm. Un exemple de procédé de réalisation de la structure 4A sera décrit plus en détails au moyen des figures 5A à 5I.

La figure 4B représente un empilement de couches adapté pour la formation de microcellules photovoltaïque avec une hétérojonction de type CdTe. Par CdTe, on entend ici de façon plus générale la famille du CdTe ou un de ses alliages ou dérivés, dans lequel le cadmium peut être substitué partiellement par le zinc ou le mercure et le tellure peut être substitué partiellement par le sélénium. Là encore, les natures des matériaux sont données ci-dessous à titre d'exemple. L'empilement comprend une couche 101 en matériau conducteur, par exemple en Or ou en alliage Nickel-Argent, pour former le contact arrière. L'épaisseur de cette couche est de l'ordre du micromètre. La couche 102 est la couche en matériau absorbant, dans cet exemple le CdTe (tellurure de cadmium) dopé p. Son épaisseur est de quelques micromètres, par exemple 6 $\mu$m. Une couche d'interface 113 en CdS dopée n est agencée entre la couche de CdTe et la couche isolante 103. Son épaisseur est d'une centaine de nanomètres. L'empilement comprend la couche 103 en matériau électriquement isolant, par exemple en SiO$_2$, structurée pour former les ouvertures permettant de définir la ou les zone(s) active(s) photovoltaïque(s). Son épaisseur est de quelques centaines de nanomètres, par exemple 400 nm. Vient ensuite la couche fenêtre 106 en matériau conducteur transparent, par exemple en ITO (oxyde d'indium-étain) ou en SnO$_2$ (dioxyde d'étain) dopé n, d'épaisseur quelques centaines de nanomètres, par exemple 400 nm et la couche 104 en matériau métallique pour assurer le contact périphérique de la microcellule, par exemple en or, structurée de façon identique à la couche isolante 103, d'épaisseur quelques centaines de nanomètres, par exemple 400 nm. Dans cet exemple, le procédé de fabrication est dit de 'haut en bas', et le substrat 109 est disposé sur la face de la cellule destinée à recevoir la lumière solaire incidente.

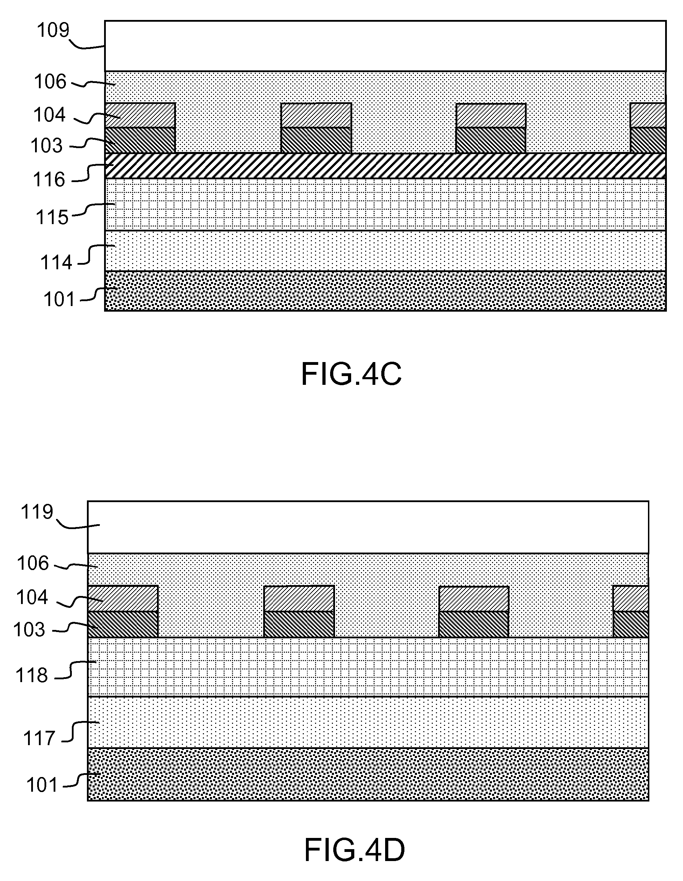

La figure 4C représente un empilement de couches adapté pour la formation de microcellules photovoltaïques utilisant la famille du silicium en couches minces et comprenant le silicium amorphe, et/ou polymorphe, microcristallin, cristallin, nanocristallin. Dans l'exemple de la figure 4C, une jonction est formée par les couches 114, 115 et 116, respectivement en silicium amorphe dopé p, silicium amorphe intrinsèque, silicium amorphe dopé n, l'ensemble de ces couches étant absorbantes dans le visible, l'épaisseur totale des trois couches étant de l'ordre de 2 $\mu$m. Les couches formant la jonction sont agencées entre le contact électrique arrière 101 (couche métallique, par exemple en aluminium ou en argent) et la couche isolante structurée 103, par exemple en SiO$_2$ d'épaisseur de l'ordre de quelques centaines de nanomètres, par exemple 400 nm. Une couche métallique avant 104, structurée comme la couche isolante et d'épaisseur sensiblement identique est agencée au-dessus, et au-dessus de celle-ci se trouve la couche fenêtre 106 en matériau transparent conducteur, par exemple en SnO$_2$, d'épaisseur également quelques centaines de nanomètres. Dans cet exemple également, le procédé est de haut en bas, le substrat étant positionné sur la face de la cellule exposée à la lumière incidente.

D'autres familles de matériaux absorbants peuvent être utilisés pour la réalisation d'une cellule photovoltaïque en couches minces selon la présente invention. Par exemple les matériaux semi-conducteurs III-V dont par exemple le GaAs (arséniure de gallium), l'InP (phosphure d'indium), le GaSb (antimoniure de gallium). Dans chacun des cas, la nature des couches pour former le dispositif photovoltaïque sera adaptée.

Le dernier exemple (Figure 4D) illustre un exemple comparatif avec du silicium cristallin. Cet exemple, correspondant à la filière traditionnelle du silicium cristallin et non à la filière couches minces, ne fait pas partie de l'invention.

Dans ce cas, les couches 117 et 118, respectivement en silicium cristallin dopé p (Bore) et silicium cristallin dopé n (Phosphore) forment une jonction, agencée entre le contact métallique arrière 101 et la couche isolante 103. L'épaisseur totale de la jonction est de quelques centaines de microns, typiquement 250 $\mu$m, ce qui rend cet exemple moins attractif qu'une réalisation en couches minces et limite la réduction possible des dimensions de la microcellule (typiquement, la dimension minimale ici sera de l'ordre de 500 $\mu$m pour limiter l'influence des recombinaisons latérales). Comme dans l'exemple précédent, la jonction est recouverte de la couche isolante 103 structurée, de la couche 104 en matériau conducteur structurée de la même manière et de la couche fenêtre 106, par exemple en SnO$_2$. Les couches 103, 104, 106 présentent une épaisseur de quelques centaines de nanomètres, par exemple 400 nm. Un substrat n'est pas nécessaire du fait de l'épaisseur des couches formant la jonction. Une couche anti-reflet 119 peut être prévue dans cet exemple, mais aussi de façon générale dans l'ensemble des exemples de réalisation.

Les figures 5A à 5F illustrent, selon un exemple, les étapes d'un procédé de fabrication d'une cellule photovoltaïque avec jonction CIGS du type de celle de la figure 4A.

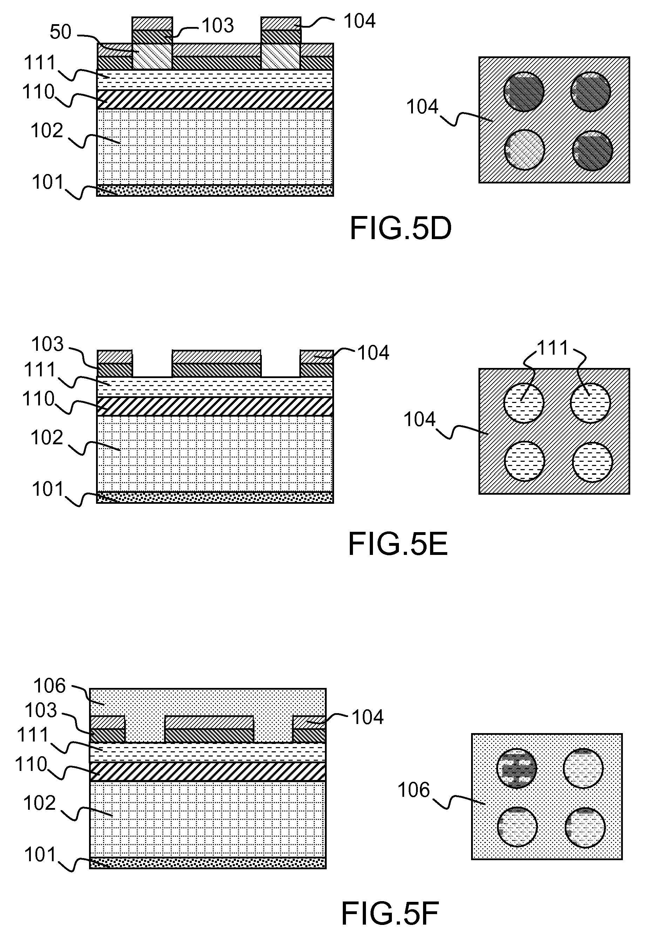

Dans une première étape (figure 5A), la structure de base est réalisée avec dépôt successif sur un substrat (non représenté) de la couche 101 en matériau conducteur (par exemple en molybdène), de la couche 102 de CIGS et des deux couches d'interface 110, 111 en CdS et iZnO respectivement. Une vue partielle du dessus de la structure de base est également représentée. Dans une seconde étape (Figure 5B) on procède au dépôt d'une couche de résine par exemple en plots circulaires 50 de diamètre adapté à la taille de microcellule que l'on cherche à réaliser. La réalisation des plots en résine est faite par exemple par un procédé connu de lithographie, consistant à enduire l'échantillon d'une couche de résine, à insoler la résine à travers un masque puis à tremper l'échantillon dans un développeur qui va permettre de dissoudre la résine sélectivement. Si la résine photosensible utilisée est de type positif, la partie qui aura été insolée sera soluble dans le développeur et la partie non exposée sera non soluble. Si la résine photosensible utilisée est de type négatif, la partie non exposée sera soluble et la partie exposée sera non soluble. La résine utilisée pour la fabrication des cellules pourra être choisie indifféremment du type positif ou négatif. Il s'ensuit le dépôt de la couche d'isolant 103 (Figure 5C), puis le dépôt de la couche en matériau conducteur 104 (Figure 5D). La dissolution de la résine (usuellement connue sous l'expression de 'lift off') est donc ensuite réalisée (figure 5E) afin d'obtenir les couches 103 et 104 de matériau isolant et conducteur structurées de manière identique avec des ouvertures circulaires laissant apparaître la surface de la couche supérieure de la jonction. Il est alors procédé (Figure 5F) au dépôt de la couche 106 en matériau conducteur transparent (par exemple Al :ZnO). Les îlots étant ainsi réalisés, une mise à nu partielle de la couche en matériau conducteur 101 peut être réalisée pour assurer la connexion en série de deux îlots, comme illustré sur la figure 2.

Les figures 5A à 5F décrivent un exemple de procédé adapté à une jonction de type CIGS dit 'de bas en haut', c'est-à-dire dans lequel les couches sont successivement déposées sur le substrat de la couche la plus basse à la couche la plus élevée par rapport à la face d'exposition à la lumière incidente. Dans le cas de jonctions de type CdTe ou silicium amorphe (Figures 4B, 4C), un procédé de type 'de haut en bas' sera plutôt adopté dans lequel on dépose d'abord sur le substrat (généralement un substrat en verre) les couches qui seront les plus proches de la face d'exposition à la lumière incidente puis on retourne la cellule lors de son utilisation. Le choix d'un procédé de haut en bas dépend notamment de l'adhérence des matériaux utilisés sur le substrat, de la difficulté que l'on peut rencontrer à 'contacter' la couche en matériau absorbant. Ainsi dans le procédé de haut en bas, on pourra procéder au dépôt sur un substrat 109 transparent de la couche 106 en matériau conducteur transparent pour former le contact électrique avant, puis le dépôt d'une couche de résine structurée pour former un ou plusieurs plots dont la forme définira la forme de la ou desdites zone(s) active(s) photovoltaïque(s), puis le dépôt sur ladite couche de résine de la couche 103 en matériau isolant, puis le lift-off de la résine et le dépôt de la couche en matériau absorbant 102 et enfin le dépôt sur la couche photoconductrice d'une couche conductrice pour former le contact arrière. Lorsque le contact avant est formé de la couche en matériau conducteur transparent 106 et d'une couche en matériau conducteur structurée 104, on pourra procéder au dépôt sur la couche de résine de la couche en matériau conducteur 104 puis de la couche isolante 103 avant de dissoudre la résine. Si comme dans l'exemple de la figure 4B, on choisit d'insérer une couche en matériau conducteur transparent 106 entre la couche en matériau conducteur 104 et la couche isolante 103, on pourra déposer les plots de résine, déposer le matériau conducteur, dissoudre la résine, déposer la couche en matériau conducteur transparent 106, refaire un dépôt de résine, déposer la couche isolante puis dissoudre la résine.

Par ailleurs, pour la réalisation de cellules photovoltaïques du type de la figure 1B, plusieurs méthodes de réalisations peuvent être considérées.

Selon un premier exemple, on procède au dépôt sur un substrat (non représenté sur la figure 1B) de la couche 101 en matériau conducteur pour former le contact électrique arrière, puis au dépôt de la couche inactive 108, avantageusement en matériau isolant, structurée pour former une ou plusieurs ouvertures. Le matériau absorbant est alors déposé sélectivement dans la ou lesdites ouverture(s) pour former la couche en matériau absorbant 102, cette couche étant discontinue. Le dépôt sélectif est réalisé par une méthode adaptée, par exemple par électrolyse ou impression, par exemple impression par jet ou sérigraphie. Le dépôt de la couche en matériau conducteur transparent 106 pour former le contact électrique avant est ensuite réalisé. Il peut être précédé par le dépôt d'une ou plusieurs couches d'interfaces, d'une couche en matériau isolant 103 structurée si la couche inactive 108 n'est pas ou pas suffisamment isolante, et de la couche en matériau conducteur structurée 104 pour former avec le matériau conducteur transparent 106 le contact électrique avant.

Selon un deuxième exemple, il est procédé au dépôt sur la couche 101 en matériau conducteur de la couche en matériau absorbant 102, ladite couche étant discontinue pour former une ou plusieurs ouverture(s), puis au dépôt sélectif dans la ou lesdite(s) ouvertures d'un matériau inactif, par exemple un matériau isolant pour former la couche inactive 108. La couche en matériau absorbant est dans cet exemple déposé par exemple par impression par jet d'encre. Comme précédemment, on procède ensuite au dépôt de la couche en matériau conducteur transparent 106 pour former le contact électrique avant, précédé éventuellement par le dépôt d'une couche en matériau isolant structurée 103, d'une ou plusieurs couches d'interfaces et de la couche en matériau conducteur structurée 104.

Selon une variante, le dépôt sélectif du matériau absorbant est fait par dépôt dudit matériau sous forme de grains, obtenus par des techniques connues, par exemple la formation à partir de méthodes de synthèse métallurgiques à haute température, ou par génération de poudres à partir de dépôts faits au préalable en phase vapeur sur des supports intermédiaires. Des grains de CIGS de un à plusieurs microns peuvent être ainsi préparés et déposés directement sur le support dans le cadre de l'invention. Alternativement, tout ou partie des couches destinées à la formation de la jonction photovoltaïque peuvent être préalablement empilées sous forme de panneaux pleine plaque par des techniques classiques (par exemple co-évaporation ou pulvérisation sous vide ou « sputtering »), puis des portions de l'empilement, de dimensions adaptées à la taille des microcellules que l'on cherche à réaliser, sont déposées sélectivement sur le support.

Selon une autre variante, le dépôt sélectif du matériau absorbant est effectué par une méthode de dépôt physique ou chimique en phase vapeur. Pour cela, on pourra utiliser des masques qui seront placés directement devant le substrat et dans lesquels des ouvertures seront réalisées afin de permettre le dépôt sélectif de la couche absorbante et éventuellement d'autres couches actives pour la formation de la jonction sur le support. Les méthodes dites de co-évaporation et de sputtering sont des exemples de méthodes utilisables dans ce contexte.

L'un ou l'autre de ces exemples de réalisation permet, grâce à l'obtention d'une couche en matériau absorbant discontinue, de limiter la quantité de matériau absorbant nécessaire à la réalisation de la cellule photovoltaïque et donc d'économiser de façon substantielle l'utilisation d'éléments chimiques rares.

Les cellules selon l'invention peuvent ainsi être réalisées par des procédés qui ne requièrent pour leur mise en oeuvre que le dépôt et la structuration d'une couche électriquement neutre et d'une couche électriquement conductrice. Ces deux couches peuvent très facilement être composées de matériaux bon marché et non nocifs pour l'environnement ($SiO_2$ comme isolant, l'Aluminium comme conducteur par exemple). Les techniques de dépôts (dépôt par pulvérisation cathodique) sont très répandues et pas particulièrement dangereuses. Les techniques employées sont celles de la microélectronique (lithographie UV) par exemple dont les risques sont limités en terme de toxicité et donc facilement mises en oeuvre. Le passage au niveau industriel peut donc être envisagé en s'appuyant sur le savoir-faire de la microélectronique.

Les simulations d'efficacité théorique réalisées par la déposante sur la base des cellules photovoltaïques précédemment décrites montrent des résultats remarquables. Le modèle utilisé est basé sur l'analyse électrique d'une cellule solaire présentant une couche avant résistive (couche fenêtre) de résistance de couche donnée. Les équations de base de ce modèle sont par exemple décrites dans N.C. Wyeth et al., Solid-State Electronics 20, 629-634 (1977) ou U.Malm et al., Progress in Photovoltaïcs, 16, 113-121 (2008). La déposante a étudié l'effet simultané de la concentration lumineuse et de la taille de la microcellule dans une architecture du type de celle décrite précédemment, avec une section circulaire de la microcellule, en utilisant une méthode de contact électrique sans utilisation de grille de collecte.

Le modèle est entièrement basé sur la résolution de l'équation :

$$\partial^2 \psi / \partial r^2 + 1/r \times \partial \psi / \partial r + R_\square (J_{ph} - J_0(\exp(q\psi / nkT) - 1) - \psi / R_{sh}) = 0$$

où $\psi$ est le potentiel électrique à une certaine distance r du centre de la cellule, $R_\square$ la résistance de couche de la couche fenêtre avant, $J_{ph}$ la densité de photocourant, $J_0$ la densité de courant d'obscurité, $R_{sh}$ la résistance de fuite, n le facteur d'idéalité de la diode, k la constante de Boltzmann, q la charge élémentaire.

Les conditions aux limites qui permettent la résolution de cette équation sont dans le cas d'un contact périphérique:

$\psi(a)$ = V où a est le rayon de la cellule et V la tension appliquée à celle-ci.

$\partial\psi/\partial r(0)$ = 0 car il n'y a pas de courant au centre de la cellule pour des raisons de symétrie.

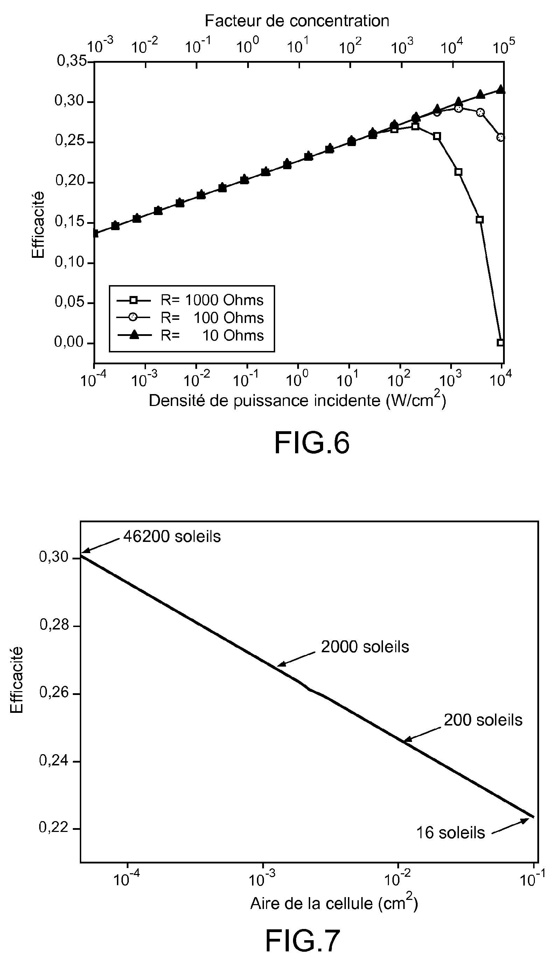

La figure 6 illustre la courbe d'efficacité calculée en fonction de la densité de puissance incidente (ou facteur de concentration en unités soleil) pour différentes résistances de couche de la couche fenêtre assurant le contact périphérique de la microcellule. Pour effectuer cette simulation, une microcellule de section circulaire a été considérée, avec un rayon de 18 $\mu$m. (soit une surface de $10^{-5}$ $cm^2$) et des paramètres électriques d'une cellule record à base de CIGS (sans concentration de lumière), à savoir un courant de court-circuit : Jsc = 35.5 mA/$cm^2$, un facteur d'idéalité de la diode n=1.14, un courant d'obscurité $J_0$ = 2.1 $10^{-9}$ mA/$cm^2$ (paramètres évalués par exemple par I.Repins et al., 33rd IEEE Photovolatic Specialists Conference, 2008, 1 - 6 (2008), ou I.Repins et al., Progress in Photovoltaics 16, 235-239 (2008)).

L'efficacité a été calculée pour trois valeurs de la résistance de couche $R_{sh}$, respectivement 10, 100 et 1000 Ohm/sq pour une puissance lumineuse variant entre $10^{-4}$ et $10^4$ W/$cm^2$, soit un facteur de concentration en unités soleil variant de $10^{-3}$ et $10^5$ (une unité soleil correspondant à 1000 W/$m^2$, soit $10^{-1}$ W/$cm^2$). Ainsi pour une résistance de couche de 1000 Ohm/sq, l'efficacité est croissante en fonction du facteur de concentration jusqu'à environ 5000 soleils, valeur au-delà de laquelle les effets de la résistance de couche affectent l'efficacité. Pour des résistances de couche inférieures à 100 Ohm/sq, la résistance n'est plus le facteur limitant principal pour le calcul de l'efficacité théorique de la cellule et on atteint des efficacités de l'ordre de 30% avec des facteurs de concentration proches de 50 000 soleils.

Ceci est remarquable en ce qu'il est alors possible de travailler avec des couches fenêtres présentant une meilleure transparence (même si la résistance est plus grande) permettant de générer des photocourants plus importants. En effet, dans le cas particulier des cellules en couches minces par exemple, l'utilisation d'un oxyde transparent conducteur en face avant oblige à un compromis entre transparence et conductivité. En effet, plus la couche fenêtre est conductrice, moins elle est transparente. La géométrie de cellule selon l'invention, qui relâche la contrainte sur la conductivité de la couche fenêtre (puisque les effets de résistance deviennent négligeables) permet d'utiliser des couches très transparentes (même si elles sont plus résistives). Un gain de l'ordre de 10% sur le photocourant est attendu (i.e. le courant généré par la lumière incidente dans la cellule), puisque la couche fenêtre absorbera moins le rayonnement incident, et qu'ainsi la partie absorbante de la cellule recevra plus de lumière.

La figure 7 illustre avec les mêmes hypothèses de calcul que précédemment, l'efficacité de la microcellule en fonction de la surface de la zone active photovoltaïque pour une résistance de couche de 10 Ohms, l'efficacité étant donnée pour la valeur du facteur de concentration optimal au-delà de laquelle l'efficacité décroît. Ces valeurs du facteur de concentration optimal sont indiquées pour 4 valeurs de la taille de la microcellule. Ainsi, pour une cellule de section de $10^{-1}$ cm$^2$, sous concentration de 16 soleils, l'efficacité calculée est de 22%. Pour une cellule de section de $10^{-2}$ cm$^2$, sous concentration de 200 soleils, l'efficacité calculée est de 24%. Pour une cellule de section de $10^{-3}$ cm$^2$, sous concentration de 2000 soleils, l'efficacité calculée est de 27% et pour une cellule de section de $10^{-5}$ cm$^2$, sous concentration de 46200 soleils, l'efficacité calculée est de 31%. Pour des microcellules de sections inférieures à 4,5 $10^{-5}$ cm$^2$, le facteur de concentration optimal est supérieur à 46 200, montrant que la résistance de couche n'est plus un facteur limitant pour les performances de la microcellule.

Comme cela apparaît au vu des résultats présentés, l'architecture originale de la cellule photovoltaïque selon l'invention permet notamment de limiter l'influence de la résistance de la couche fenêtre et d'employer ainsi des concentrations beaucoup plus élevées, associées à de meilleurs rendements de conversion. Plusieurs avantages sont attendus. L'utilisation de microcellules sous flux concentré permet notamment de réduire le rapport entre la quantité de matières premières employée et l'énergie produite. Une économie de matériau d'un facteur supérieur ou égal à la concentration lumineuse pourra être réalisée. L'énergie produite par gramme de matière première employée pourrait être multipliée par un facteur de cent ou même plusieurs milliers, suivant la concentration lumineuse employée. Ceci est principalement important pour des matériaux comme l'Indium dont la disponibilité est limitée. Par ailleurs, l'utilisation sous concentration lumineuse de matériau de qualité moyenne pourrait permettre d'en tirer le meilleur parti, puisqu'il est connu que l'utilisation sous flux concentré permet de saturer les défauts électriques du matériau. La saturation de ces défauts permet ainsi de rendre leur influence de moins en moins importante dans le bilan de la cellule. Des rendements très importants pourraient donc être obtenus à partir d'un matériau qui sans concentration reste médiocre. Ceci signifie par exemple que des matériaux à coût limité pourraient être adapté à l'utilisation sous concentration.

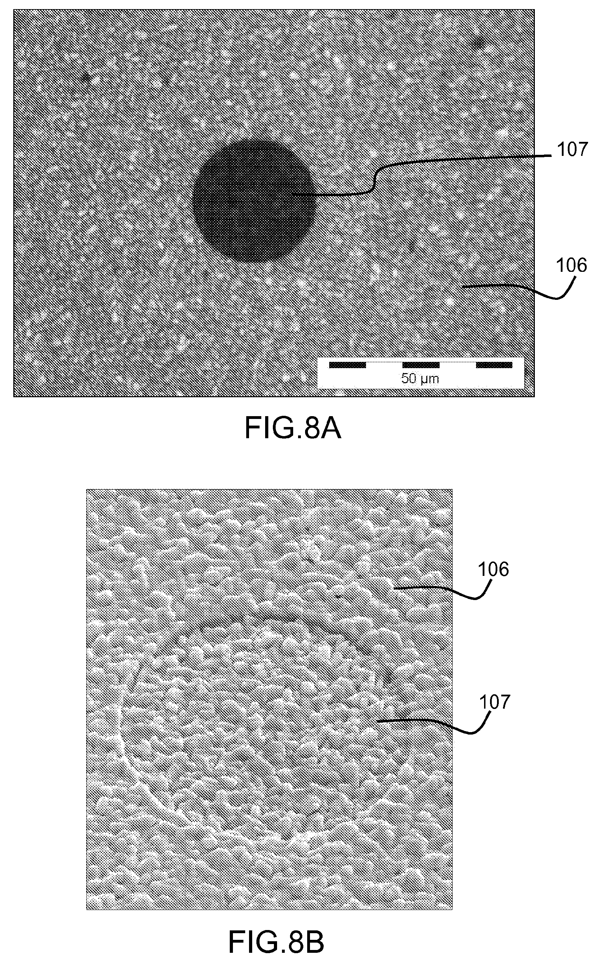

Les déposants ont procédé aux premières réalisations expérimentales de microcellules selon un exemple de procédé décrit dans la présente invention. Les figures 8A et 8B montrent des photographies vues de dessus d'une microcellule à base de CIGS respectivement prises avec un microscope optique (figure 8A) et avec un microscope à balayage électronique (MEB) (figure 8B). Les microcellules ont été réalisées selon le procédé décrit en référence aux figures 5A à 5F avec des sections rondes de diamètres variant entre 10 $\mu$m et 500 $\mu$m. Les microcellules représentées sur les figures 8A et 8B montrent des microcellules de diamètre 35 $\mu$m. Sur ces photographies, la référence 106 représente la couche fenêtre en Al :ZnO déposée sur la couche 104 et la référence 107 indique la surface d'exposition correspondant à la zone active photovoltaïque. Avec ces cellules, les déposants ont enregistré des premiers résultats très prometteurs, montrant un effet bénéfique de la taille de la microcellule sur les performances sous concentration sans dégradation des matériaux, même sous les plus fortes densités testées (100 fois plus que décrit précédemment dans la littérature, voir par exemple l'article de J.Ward et al. précédemment cité). Notamment, des densités de courant équivalents à une concentration de 3000 soleils ont été obtenues dans la microcellule (densité de courant supérieure à 100 A/cm$^2$).

Bien que décrite à travers un certain nombre d'exemples de réalisation détaillés, la cellule photovoltaïque et la méthode de réalisation de la cellule selon l'invention comprennent différentes variantes, modifications et perfectionnements qui apparaîtront de façon évidente à l'homme de l'art, et qui doivent être considérés comme faisant partie de l'invention dès l'instant où ils tombent sous la portée des revendications qui suivent.

## Revendications

1. Composant photovoltaïque (10) en couches minces pour application sous flux solaire concentré comprenant :

   - un substrat (109)
   - un ensemble de couches (101, 102, 105, 106) adaptée à la réalisation d'un dispositif photovoltaïque, dont au moins une première couche (101) en matériau conducteur pour former un contact électrique arrière, une deuxième couche (102) en matériau absorbant dans le spectre solaire, une troisième couche (106) en matériau conducteur transparent et une couche en matériau conducteur (104), en contact électrique avec ladite troisième couche en matériau conducteur transparent (106), pour former avec ladite troisième couche (106) un contact électrique avant, et

- une couche (103, 103$_A$) en matériau isolant électrique, agencée entre ledit contact électrique arrière et ledit contact électrique avant, et structurée pour présenter une pluralité d'ouvertures dans laquelle lesdites couches dudit ensemble de couches s'empilent pour former un ensemble de microcellules photovoltaïques (100), chaque ouverture formée dans la couche en matériau isolant électrique définissant la forme et les dimensions d'une section d'une microcellule photovoltaïque (100) ;

- dans lequel la couche en matériau conducteur (104) est structurée pour former des ouvertures qui se superposent à celles des ouvertures de ladite couche en matériau isolant électrique (103), de telle sorte à former un contact électrique périphérique pour chacune desdites microcellules photovoltaïques formées, lesdites microcellules photovoltaïques étant connectées électriquement en parallèle par le contact électrique arrière et le contact électrique avant, et

- dans lequel chacune desdites couches du composant photovoltaïque, d'épaisseur inférieure à environ 20$\mu$m, est obtenue par dépôt en phase liquide ou en phase vapeur sur le substrat (109).

**2.** Composant photovoltaïque selon la revendication 1, dans lequel le dit matériau conducteur de ladite couche en matériau conducteur (104) en contact électrique avec ladite troisième couche en matériau conducteur transparent (106) est un métal choisi parmi l'aluminium, le molybdène, le cuivre, le nickel, l'or, l'argent, le carbone et les dérivés du carbone, le platine, le tantale, le titane.

**3.** Composant photovoltaïque selon l'une des revendications 1 ou 2, dans lequel ladite première couche en matériau conducteur (101) du contact arrière étant transparente, il comprend en outre une couche (104$_B$) en matériau conducteur, en contact électrique avec ladite première couche en matériau conducteur transparent (101) pour former avec ladite première couche (101) le contact électrique arrière, et structurée de telle sorte à former un contact électrique périphérique pour lesdites microcellules photovoltaïques.

**4.** Composant photovoltaïque selon l'une des revendications précédentes, comprenant une seconde couche en matériau isolant (103$_B$) agencée entre ledit contact électrique arrière et ledit contact électrique avant, structurée de telle sorte à présenter des ouvertures centrées sur lesdites ouvertures de la première couche en matériau isolant, de dimensions égales.

**5.** Composant photovoltaïque selon l'une des revendications précédentes, dans lequel ledit matériau isolant est choisi parmi les oxydes tels que la silice ou l'alumine, les nitrures tels que le nitrure de silicium, les sulfures tels que le sulfure de zinc.

**6.** Composant photovoltaïque selon l'une des revendications précédentes, dans lequel au moins une dimension de la section de chacune desdites microcellules photovoltaïques est inférieure à 100 $\mu$m.

**7.** Composant photovoltaïque selon l'une des revendications précédentes, dans lequel au moins une partie des microcellules photovoltaïques formées sont de section circulaire, de surface inférieure à 10$^{-4}$ cm$^2$.

**8.** Composant photovoltaïque selon l'une des revendications précédentes, dans lequel au moins une microcellule photovoltaïque formée est de section allongée, en forme de bande, de plus petite dimension inférieure à 100 $\mu$m.

**9.** Composant photovoltaïque selon l'une des revendications précédentes, dans lequel ladite couche en matériau absorbant est discontinue, formée à l'endroit desdites microcellules photovoltaïques.

**10.** Composant photovoltaïque selon la revendication 9, comprenant en outre une couche (108), inactive pour le dispositif photovoltaïque, présentant des ouvertures à l'endroit desquelles est sélectivement disposée ladite couche en matériau absorbant.

**11.** Composant photovoltaïque selon l'une des revendications précédentes, dans lequel chacune desdites couches formant le composant présente une épaisseur inférieure à environ 5 $\mu$m.

**12.** Composant photovoltaïque selon l'une quelconque des revendications précédentes, dans lequel le matériau absorbant appartient à l'une des familles parmi la famille du CIGS, la famille du CdTe, la famille du silicium, la famille des semi-conducteurs III-V.

**13.** Ensemble de composants photovoltaïques selon l'une des revendications précédentes, dans lequel lesdits composants photovoltaïques sont connectés électriquement en série, le contact avant d'un composant photovoltaïque étant connecté électriquement au contact arrière du composant photovoltaïque adjacent.

14. Module photovoltaïque comprenant un composant photovoltaïque selon l'une des revendications 1 à 12 ou un ensemble de composants photovoltaïques selon la revendication 13 et comprenant en outre un système (11) de concentration de la lumière solaire adapté pour focaliser tout ou partie de la lumière incidente (12) sur chacune desdites microcellules photovoltaïques du ou des composants photovoltaïques(s).

15. Module photovoltaïque comprenant un composant photovoltaïque ou un ensemble de composants photovoltaïques selon la revendication 13, et comprenant en outre un élément de conversion de la longueur d'onde de la lumière incidente dans une bande spectrale d'absorption du matériau absorbant agencé sous ladite première couche en matériau conducteur transparent (101) du contact arrière.

16. Méthode de fabrication d'un composant photovoltaïque en couches minces selon la revendication 1 comprenant :

    - le dépôt sur un substrat (109) de ladite première couche (101) en matériau conducteur pour former le contact électrique arrière,
    - le dépôt d'une couche (108) en matériau inactif pour le dispositif photovoltaïque, électriquement isolant, ladite couche inactive étant structurée pour former une pluralité d'ouvertures,
    - le dépôt sélectif du matériau absorbant dans lesdites ouvertures pour former ladite couche en matériau absorbant (102), ladite couche étant discontinue,
    - le dépôt d'une couche en matériau électriquement isolant (103) structurée pour présenter des ouvertures inférieures ou égales à celles de ladite couche inactive (108),
    - le dépôt de ladite couche (104) en matériau conducteur, structurée de telle sorte à former des ouvertures de dimensions inférieures ou égales à celles des ouvertures de ladite couche inactive,
    - le dépôt de ladite troisième couche en matériau conducteur transparent (106) pour former le contact électrique avant des microcellules photovoltaïques, en contact électrique avec ladite couche (104) en matériau conducteur.

17. Méthode de fabrication d'un composant photovoltaïque en couches minces selon la revendication 1 comprenant :

    - le dépôt sur un substrat (109) de ladite première couche (101) en matériau conducteur pour former le contact électrique arrière,
    - le dépôt de ladite deuxième couche en matériau absorbant (102), ladite deuxième couche étant discontinue pour former une pluralité d'ouvertures,
    - le dépôt sélectif dans lesdites ouvertures d'un matériau inactif dans le dispositif photovoltaïque, électriquement isolant, pour former une couche inactive discontinue (108) avec des ouvertures à l'endroit du matériau absorbant,
    - le dépôt d'une couche en matériau électriquement isolant (103) structurée pour présenter des ouvertures inférieures ou égales à celles de ladite couche inactive (108),
    - le dépôt de ladite couche (104) en matériau conducteur, structurée de telle sorte à former des ouvertures de dimensions inférieures ou égales à celles des ouvertures de ladite couche inactive,
    - le dépôt de ladite troisième couche en matériau conducteur transparent (106) en contact électrique avec ladite couche en matériau conducteur (104) pour former le contact électrique avant.

18. Méthode de fabrication d'un composant photovoltaïque en couches minces selon la revendication 1, comprenant :

    - le dépôt sur un substrat (109) de ladite première couche (101) en matériau conducteur pour former le contact électrique arrière et de ladite deuxième couche en matériau absorbant (102),
    - le dépôt d'une couche de résine structurée pour former une pluralité de plots dont la forme définira la forme de chacune desdites microcellules photovoltaïques,
    - le dépôt sur ladite couche de résine d'une couche (103) en matériau isolant et d'une couche (104) en matériau conducteur,
    - le lift-off de la résine permettant d'obtenir lesdites couches (103) en matériau isolant et (104) en matériau conducteur structurées, et le dépôt de ladite troisième couche en matériau conducteur transparent (106), en contact électrique avec ladite couche en matériau conducteur structurée, pour former le contact électrique avant.

19. Méthode de fabrication d'un composant photovoltaïque en couches minces selon la revendication 1 comprenant :

    - le dépôt sur un substrat (109) transparent de ladite troisième couche (106) en matériau conducteur transparent pour former le contact électrique avant,

- le dépôt d'une couche de résine structurée pour former une pluralité de plots dont la forme définira la forme de chacune des microcellules photovoltaïques,
- le dépôt sur ladite couche de résine d'une couche (104) en matériau conducteur et d'une couche (103) en matériau isolant,
- le lift-off de la résine permettant d'obtenir lesdites couches (103) en matériau isolant et (104) en matériau conducteur structurées, et le dépôt de ladite deuxième couche en matériau absorbant (102),
- le dépôt de ladite première couche (101) en matériau conducteur pour former le contact électrique arrière.

**20.** Méthode de fabrication d'un composant photovoltaïque selon la revendication 19, dans laquelle ladite deuxième couche (102) en matériau absorbant est déposée de façon sélective et forme une couche discontinue.


**Patentansprüche**

**1.** Fotovoltaisches Bauteil (10) in dünnen Schichten zur Verwendung unter konzentrierter Sonnenstrahlung mit:

- einem Substrat (109),
- einer Gesamtheit von Schichten (101, 102, 105, 106), die zur Realisierung einer fotovoltaischen Vorrichtung geeignet sind, darunter wenigstens eine erste Schicht (101) aus leitendem Material, um einen hinteren elektrischen Kontakt zu bilden, eine zweite Schicht (102) aus im Sonnenspektrum absorbierendem Material, eine dritte Schicht (106) aus transparentem leitenden Material und eine Schicht aus leitendem Material (104), die mit der dritten Schicht aus transparentem leitenden Material (106) elektrisch in Kontakt steht, um mit dieser dritten Schicht (106) einen vorderen elektrischen Kontakt zu gewährleisten, und
- einer Schicht (103, 103$_A$) aus elektrisch isolierendem Material, welche zwischen diesem hinteren elektrischen Kontakt und der dritten Schicht (106) aus transparentem leitenden Material angeordnet und derart strukturiert ist, dass sie eine Vielzahl von Öffnungen aufweist, in denen die Schichten dieser Gesamtheit von Schichten sich stapeln, um eine Gesamtheit von fotovoltaischen Mikrozellen (100) zu bilden, wobei jede in der Schicht aus elektrisch isolierendem Material gebildete Öffnung die Form und die Abmessungen eines Querschnitts einer fotovoltaischen Mikrozelle (100) definiert,
- wobei die Schicht aus leitendem Material (104) derart strukturiert ist, dass sie Öffnungen bildet, die sich mit den Öffnungen der Schicht aus elektrisch isolierendem Material (103) derart überlagern, dass sie einen peripheren elektrischen Kontakt für jede der gebildeten fotovoltaischen Mikrozellen bilden, wobei diese fotovoltaischen Mikrozellen durch den hinteren elektrischen Kontakt und den vorderen elektrischen Kontakt elektrisch parallel geschaltet sind, und
- wobei jede dieser Schichten des fotovoltaischen Bauteils mit einer Dicke kleiner ungefähr 20 $\mu$m durch Auftragen in der Flüssigphase oder Dampfphase auf das Substrat (109) erzeugt wird.

**2.** Fotovoltaisches Bauteil nach Anspruch 1, **dadurch gekennzeichnet, dass** das leitende Material der mit der dritten Schicht aus transparentem leitenden Material (106) elektrisch in Kontakt stehenden Schicht aus leitendem Material (104) ein Metall wie etwa Aluminium, Molybdän, Kupfer, Nickel, Gold, Silber, Kohlenstoff und Kohlenstoffderivate, Platin, Tantal, Titan ist.

**3.** Fotovoltaisches Bauteil nach einem der Ansprüche 1 oder 2, **dadurch gekennzeichnet, dass** die erste Schicht aus leitendem Material (101) des hinteren Kontakts transparent ist und es ferner eine Schicht (104$_B$) aus leitendem Material umfasst, die mit dieser ersten Schicht aus transparentem leitenden Material (101) elektrisch in Kontakt steht, um mit der ersten Schicht (101) den hinteren elektrischen Kontakt zu bilden, und derart strukturiert ist, dass sie einen peripheren elektrischen Kontakt für die fotovoltaischen Mikrozellen bildet.

**4.** Fotovoltaisches Bauteil nach einem der vorhergehenden Ansprüche, **dadurch gekennzeichnet, dass** es eine zweite Schicht aus isolierendem Material (103$_B$) umfasst, die zwischen dem hinteren elektrischen Kontakt und dem vorderen elektrischen Kontakt angeordnet und derart strukturiert ist, dass sie Öffnungen aufweist, die auf die Öffnungen der ersten Schicht aus isolierendem Material mit denselben Abmessungen zentriert sind.

**5.** Fotovoltaisches Bauteil nach einem der vorhergehenden Ansprüche, **dadurch gekennzeichnet, dass** das isolierende Material ein Oxid wie etwa Siliciumoxid oder Aluminiumoxid, Nitrid wie etwa Siliciumnitrid oder Sulfid wie etwa Zinksulfid ist.

**6.** Fotovoltaisches Bauteil nach einem der vorhergehenden Ansprüche, **dadurch gekennzeichnet, dass** wenigstens eine Abmessung des Querschnitts jeder fotovoltaischen Mikrozelle kleiner als 100 μm ist.

7. Fotovoltaisches Bauteil nach einem der vorhergehenden Ansprüche, **dadurch gekennzeichnet, dass** wenigstens ein Teil der gebildeten fotovoltaischen Mikrozellen einen kreisförmigen Querschnitt mit einer Fläche kleiner $10^{-4}$ cm$^2$ aufweist.

8. Fotovoltaisches Bauteil nach einem der vorhergehenden Ansprüche, **dadurch gekennzeichnet, dass** wenigstens eine der gebildeten fotovoltaischen Mikrozellen einen länglichen, bandförmigen Querschnitt mit einer kleineren Abmessung unter 100 μm aufweist.

9. Fotovoltaisches Bauteil nach einem der vorhergehenden Ansprüche, **dadurch gekennzeichnet, dass** die Schicht aus absorbierendem Material diskontinuierlich und im Bereich der fotovoltaischen Mikrozellen gebildet ist.

10. Fotovoltaisches Bauteil nach Anspruch 9, **dadurch gekennzeichnet, dass** es ferner eine für die fotovoltaische Vorrichtung inaktive Schicht (108) umfasst, die Öffnungen aufweist, in deren Bereich diese Schicht aus absorbierendem Material selektiv angeordnet ist.

11. Fotovoltaisches Bauteil nach einem der vorhergehenden Ansprüche, **dadurch gekennzeichnet, dass** jede der Schichten, die das Bauteil bilden, eine Dicke kleiner ungefähr 5 μm aufweist.

12. Fotovoltaisches Bauteil nach einem der vorhergehenden Ansprüche, **dadurch gekennzeichnet, dass** das absorbierende Material zur CIGS-Gruppe, CdTe-Gruppe, Silicium-Gruppe oder III-V-Halbleitergruppe gehört.

13. Gesamtheit von fotovoltaischen Bauteilen nach einem der vorhergehenden Ansprüche, **dadurch gekennzeichnet, dass** diese fotovoltaischen Bauteile elektrisch in Serie geschaltet sind, wobei der vordere Kontakt eines fotovoltaischen Bauteils mit dem hinteren Kontakt des angrenzenden fotovoltaischen Bauteils elektrisch verbunden ist.

14. Fotovoltaisches Modul mit einem fotovoltaischen Bauteil nach einem der Ansprüche 1 bis 12 oder einer Gesamtheit von fotovoltaischen Bauteilen nach Anspruch 13, **dadurch gekennzeichnet, dass** es ferner ein System (11) zur Konzentration des Sonnenlichts umfasst, das geeignet ist, einen Teil oder die Gesamtheit des auf jede fotovoltaische Mikrozelle des oder der fotovoltaischen Bauteile(s) auftreffenden Lichts (12) zu bündeln.

15. Fotovoltaisches Modul mit einem fotovoltaischen Bauteil oder einer Gesamtheit von fotovoltaischen Bauteilen nach Anspruch 13, **dadurch gekennzeichnet, dass** es ferner ein Element zur Umwandlung der Wellenlänge des einfallenden Lichts in eine Spektralabsorptionsbande des absorbierenden Materials umfasst, welches unter der ersten Schicht aus transparentem leitenden Material (101) des hinteren Kontakts angeordnet ist.

16. Herstellungsmethode eines fotovoltaischen Bauteils in dünnen Schichten nach Anspruch 1, welche umfasst:

   - Auftrag der ersten Schicht (101) aus leitendem Material auf ein Substrat (109), um den hinteren elektrischen Kontakt zu bilden,
   - Auftrag einer Schicht (108) aus einem elektrisch isolierenden, für die fotovoltaische Vorrichtung inaktiven Material, wobei diese inaktive Schicht strukturiert ist, um eine Vielzahl von Öffnungen zu bilden,
   - selektiver Auftrag des absorbierenden Materials in diesen Öffnungen, um die Schicht aus absorbierendem Material (102) zu bilden, wobei diese Schicht diskontinuierlich ist,
   - Auftrag einer Schicht aus elektrisch isolierendem Material (103), die derart strukturiert ist, dass sie kleinere oder gleiche Öffnungen wie die inaktive Schicht (108) aufweist,
   - Auftrag der Schicht (104) aus leitendem Material, die derart strukturiert ist, dass sie Öffnungen mit kleineren oder denselben Abmessungen wie die Öffnungen der inaktiven Schicht bildet,
   - Auftrag der dritten Schicht aus transparentem leitenden Material (106), um den vorderen elektrischen Kontakt der fotovoltaischen Mikrozellen zu bilden, wobei diese mit der Schicht (104) aus leitendem Material elektrisch in Kontakt steht.

17. Herstellungsmethode eines fotovoltaischen Bauteils in dünnen Schichten nach Anspruch 1, welche umfasst:

   - Auftrag der ersten Schicht (101) aus leitendem Material auf ein Substrat (109), um den hinteren elektrischen Kontakt zu bilden,
   - Auftrag der zweiten Schicht aus absorbierendem Material (102), wobei diese zweite Schicht diskontinuierlich ist, um eine Vielzahl von Öffnungen zu bilden,

- selektiver Auftrag eines elektrisch isolierenden, in der fotovoltaischen Vorrichtung inaktiven Materials in diesen Öffnungen, um eine diskontinuierliche inaktive Schicht (108) mit Öffnungen im Bereich des absorbierenden Materials zu bilden,

- Auftrag einer Schicht aus elektrisch isolierendem Material (103), die derart strukturiert ist, dass sie kleinere oder gleiche Öffnungen wie die inaktive Schicht (108) aufweist,

- Auftrag der Schicht (104) aus leitendem Material, die derart strukturiert ist, dass sie Öffnungen mit kleineren oder denselben Abmessungen wie die Öffnungen der inaktiven Schicht bildet,

- Auftrag der dritten Schicht aus transparentem leitenden Material (106), die mit der Schicht aus leitendem Material (104) elektrisch in Kontakt steht, um den vorderen elektrischen Kontakt zu bilden.

**18.** Herstellungsmethode eines fotovoltaischen Bauteils in dünnen Schichten nach Anspruch 1, welche umfasst:

- Auftrag der ersten Schicht (101) aus leitendem Material auf ein Substrat (109), um den hinteren elektrischen Kontakt zu bilden, und der zweiten Schicht aus absorbierendem Material (102),

- Auftrag einer Harzschicht, die strukturiert ist, um eine Vielzahl von Blöcken zu bilden, deren Form die Form jeder fotovoltaischen Mikrozelle definiert,

- Auftrag einer Schicht (103) aus isolierendem Material und einer Schicht (104) aus leitendem Material auf diese Harzschicht,

- Lift-off des Harzes, um die strukturierten Schichten (103) aus isolierendem Material und (104) aus leitendem Material zu erhalten, und Auftrag der dritten Schicht aus transparentem leitenden Material (106), die mit der strukturierten Schicht aus leitendem Material elektrisch in Kontakt steht, um den vorderen elektrischen Kontakt zu bilden.

**19.** Herstellungsmethode eines fotovoltaischen Bauteils in dünnen Schichten nach Anspruch 1, welche umfasst:

- Auftrag der dritten Schicht (106) aus transparentem leitenden Material auf ein transparentes Substrat (109), um den vorderen elektrischen Kontakt zu bilden,

- Auftrag einer Harzschicht, die strukturiert ist, um eine Vielzahl von Blöcken zu bilden, deren Form die Form jeder fotovoltaischen Mikrozelle definiert,

- Auftrag einer Schicht (104) aus leitendem Material und einer Schicht (103) aus isolierendem Material auf diese Harzschicht,

- Lift-off des Harzes, um die strukturierten Schichten (103) aus isolierendem Material und (104) aus leitendem Material zu erhalten, und Auftrag der zweiten Schicht aus absorbierendem Material (102),

- Auftrag der ersten Schicht (101) aus leitendem Material, um den hinteren elektrischen Kontakt zu bilden.

**20.** Herstellungsmethode eines fotovoltaischen Bauteils nach Anspruch 19, **dadurch gekennzeichnet, dass** die zweite Schicht (102) aus absorbierendem Material selektiv aufgetragen wird und eine diskontinuierliche Schicht bildet.

## Claims

**1.** A thin-film photovoltaic component (10) for use under concentrated solar flux comprising:

- a substrate (109),

- a set of layers (101, 102, 105, 106) adapted for the implementation of a photovoltaic device, including at least one first layer (101) made of a conductive material so as to form a back electrical contact, a second layer (102) made of a material that is absorbent within the solar spectrum, a third layer (106) made of a transparent conductive material and a layer (104) made of a conductive material, making electrical contact with said third layer (106) made of a transparent conductive material, so as to form with said third layer (106) a front electrical contact, and

- a layer (103, $103_A$) made of an electrically insulating material, positioned between said back electrical contact and front back electrical contact, and structured so as to form a plurality of apertures in which said layers of said set of layers are stacked so as to form a plurality of photovoltaic microcells (100), each aperture formed in the layer made of an electrically insulating material defining the shape and the dimensions of one section of one photovoltaic microcell (100);

- wherein the layer (104) made of a conductive material is structured so as to form apertures that are superimposed with the apertures of said layer made of an electrically insulating material (103), in such a way as to form a peripheral electrical contact for each of said photovoltaic microcells formed, said photovoltaic microcells being electrically connected in parallel by the back electrical contact and the front electrical contact, and
- wherein each of the said layers of the photovoltaic component, with a thickness of less than about 20 $\mu$m, has been obtained by liquid phase or gas phase deposition on the substrate (109).

2. The photovoltaic component according to claim 1, wherein said conductive material of said layer (104) made of a conductive material in electrical contact with said third layer (106) made of a transparent conductive material is a metal chosen from aluminum, molybdenum, copper, nickel, gold, silver, carbon and carbon derivatives, platinum, tantalum and titanium.

3. The photovoltaic component according to either claim 1 or claim 2, wherein, said first layer (101) made of a conductive material of the back contact being transparent, it further comprises a layer ($104_B$) made of a conductive material, making electrical contact with said first layer (101) made of a transparent conductive material so as to form the back electrical contact with said first layer (101), and structured in such a way as to form a peripheral electrical contact for said photovoltaic microcells.

4. The photovoltaic component according to one of the preceding claims, comprising a second layer ($103_B$) made of an insulating material positioned between said back electrical contact and said front electrical contact, structured in such a way as to form apertures centered on said apertures of the first layer made of an insulating material, of equal dimensions.

5. The photovoltaic component according to one of the preceding claims, wherein said insulating material is chosen from oxides such as silica or aluminum oxide, nitrides such as silicon nitride, and sulfides such as zinc sulfide.

6. The photovoltaic component according to one of the preceding claims, wherein at least one dimension of the section of each of said photovoltaic microcells is smaller than 100 $\mu$m.

7. The photovoltaic component according to one of the preceding claims, wherein at least some of the photovoltaic microcells formed have a circular section with a surface area smaller than $10^{-4}$ cm$^2$.

8. The photovoltaic component according to one of the preceding claims, wherein at least one of the photovoltaic microcells formed has an elongated section, in the shape of a ribbon, with the smallest dimension less than 100 $\mu$m.

9. The photovoltaic component according to one of the preceding claims, wherein said layer made of an absorbent material is discontinuous, formed at said photovoltaic microcells.

10. The photovoltaic component according to claim 9, further comprising a layer (108) that is inactive with respect to the photovoltaic device, with apertures in the locations of which said absorbent material is selectively placed.

11. The photovoltaic component according to one of the preceding claims, wherein each of said layers forming the component has a thickness of less than 5 $\mu$m.

12. The photovoltaic component according to any one of the preceding claims, wherein the absorbent material belongs to a family chosen from the CIGS family, the CdTe family, the silicon family, and the III-V semiconductor family.

13. A set of photovoltaic components according to one of the preceding claims, wherein said photovoltaic components are electrically connected in series, the front contact of one photovoltaic component being electrically connected to the back contact of the adjacent photovoltaic component.

14. A photovoltaic module comprising a photovoltaic component according to one of the claims 1 to 12, or a set of photovoltaic components according to claim 13 and further comprising a system (11) for concentrating solar light configured for focusing all or some of the incident light (12) on each of said photovoltaic microcells of one or more photovoltaic components.

15. The photovoltaic module comprising a photovoltaic component or a set of photovoltaic components according to claim 13, and further comprising an element for converting the wavelength of the incident light to within an absorption spectral band of the absorbent material positioned under said first layer (101) made of a transparent conductive material of the back contact.

**16.** A method for manufacturing a thin-film photovoltaic component according to claim 1, comprising:

- depositing on a substrate (109) said first layer (101) made of a conductive material so as to form the back electrical contact,
- depositing a layer (108) made of a material that is inactive with respect to the photovoltaic device, electrically insulating, said inactive layer being structured so as to form a plurality of apertures,
- selectively depositing the absorbent material in said apertures so as to form said layer (102) made of an absorbent material, said layer being discontinuous,
- depositing a layer (103) made of an electrically isolating material structured so as to form apertures smaller than or equal to those in said inactive layer (108),
- depositing said layer (104) made of a conductive material, structured in such a way as to form apertures of smaller or equal dimensions to those of the apertures in said inactive layer,
- depositing said third layer (106) made of a transparent conductive material so as to form the front electrical contact of the photovoltaic microcells, making electrical contact with said layer (104) made of a conductive material.

**17.** A method for manufacturing a thin-film photovoltaic component according to claim 1, comprising:

- depositing on a substrate (109) said first layer (101) made of a conductive material so as to form the back electrical contact,
- depositing said second layer (102) made of an absorbent material, said second layer being discontinuous to form a plurality of apertures,
- selectively depositing in said apertures a material that is inactive with respect to the photovoltaic device, electrically insulating, so as to form a discontinuous inactive layer (108) with the apertures in the location of the absorbent material,
- depositing said layer (103) made of an electrically insulating material structured so as to form apertures smaller than or equal to those of said inactive layers (108),
- depositing said layer (104) made of a conductive material, structured in such a way as to form apertures of smaller or equal dimensions to those of the apertures in said inactive layer, and
- depositing said third layer (106) made of a transparent conductive material, in electrical contact with said layer (104) made of a conductive material, so as to form the front electrical contact.

**18.** A method for manufacturing a thin-film photovoltaic component according to claim 1, comprising:

- depositing on a substrate (109) said first layer (101) made of a conductive material so as to form the back electrical contact and said second layer (102) made of an absorbent material,
- depositing a layer of resist structured so as to form a plurality of pads the shape of which will define the shape of each of said photovoltaic microcells,
- depositing on said resist layer a layer (103) made of an insulating material and a layer (104) made of a conductive material,
- lifting off the resist in order to obtain said structured layers (103) made of an insulating material and (104) made of a conductive material, and depositing said third layer (106) made of a transparent conductive material, in electrical contact with said structured layer made of a conductive material, so as to form the front electrical contact.

**19.** A method for manufacturing a thin-film photovoltaic component according to claim 1, comprising:

- depositing on a transparent substrate (109) said third layer (106) made of a transparent conductive material so as to form the front electrical contact,
- depositing a layer of resist structured so as to form a plurality of pads the shape of which will define the shape of each of said photovoltaic microcells,
- depositing on said resist layer a layer (104) made of a conductive material and a layer (103) made of an insulating material,
- lifting off the resist in order to obtain said structured layers (103) made of an insulating material and (104) made of a conductive material, and depositing said second layer (102) made of an absorbent material,
- depositing said first layer (101) made of a conductive material so as to form the back electrical contact.

**20.** The method for manufacturing a photovoltaic component according to claim 19, wherein said second layer (102) made of an absorbent material is deposited selectively and forms a discontinuous layer.

FIG.1A

FIG.1B

FIG.1C

FIG.2

FIG.3B

106
104
302
103
301
112
102
101
109

FIG.3A

104
302
106
103
301
112
102
101
109

FIG.3C

FIG.3D

EP 2 577 737 B1

106
104
103
111
110
102
101
109

## FIG.4A

109
104
106
103
113
102
101

## FIG.4B

109

106

104

103

116

115

114

101

## FIG.4C

119

106

104

103

118

117

101

## FIG.4D

FIG.5A

FIG.5B

FIG.5C

50
111
110
102
101
103
104

FIG.5D

104

103
111
110
102
101
104

111
104

FIG.5E

106
103
111
110
102
101
104

106

FIG.5F

FIG.6

FIG.7

107

106

50 μm

FIG.8A

106

107

FIG.8B

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- JP 2008124381 B

**Littérature non-brevet citée dans la description**

- **J.WARD et al.** Cu(In,Ga)Se2 Thin film concentrator Solar Cells. *Progress in Photovoltaics,* 2002, vol. 10, 41-46
- **N.C. WYETH et al.** *Solid-State Electronics,* 1977, vol. 20, 629-634
- **U.MALM et al.** *Progress in Photovoltaïcs,* 2008, vol. 16, 113-121
- **I.REPINS et al.** *IEEE Photovolatic Specialists Conference,* 2008, 1-6
- **I.REPINS et al.** *Progress in Photovoltaics,* 2008, vol. 16, 235-239